(19) **Europäisches Patentamt**
**European Patent Office**
**Office européen des brevets**

(11) **EP 2 119 686 B1**

(12) **EUROPEAN PATENT SPECIFICATION**

(45) Date of publication and mention
of the grant of the patent:
**20.08.2014 Bulletin 2014/34**

(51) Int Cl.:
**C04B 35/475** *(2006.01)* **H01L 41/187** *(2006.01)*

(21) Application number: **07860261.2**

(86) International application number:
**PCT/JP2007/075032**

(22) Date of filing: **26.12.2007**

(87) International publication number:
**WO 2008/081842 (10.07.2008 Gazette 2008/28)**

(54) **PIEZOELECTRIC CERAMIC MATERIAL AND PIEZOELECTRIC ELEMENT**

PIEZOELEKTRISCHES KERAMIKMATERIAL UND PIEZOELEKTRISCHES ELEMENT

MATÉRIAU CÉRAMIQUE PIÉZOÉLECTRIQUE ET ÉLÉMENT PIÉZOÉLECTRIQUE

(84) Designated Contracting States:
**AT BE BG CH CY CZ DE DK EE ES FI FR GB GR HU IE IS IT LI LT LU LV MC MT NL PL PT RO SE SI SK TR**

(30) Priority: **26.12.2006 JP 2006349051**
**26.01.2007 JP 2007016331**
**15.05.2007 JP 2007129389**
**27.07.2007 JP 2007195924**

(43) Date of publication of application:
**18.11.2009 Bulletin 2009/47**

(73) Proprietor: **Kyocera Corporation**
**Kyoto-shi**
**Kyoto 612-8501 (JP)**

(72) Inventor: **IWASHITA, Shuzo**
**Kirishima-shi**
**Kagoshima 899-4312 (JP)**

(74) Representative: **HOFFMANN EITLE**
**Patent- und Rechtsanwälte**
**Arabellastrasse 4**
**81925 München (DE)**

(56) References cited:
**JP-A- 2001 097 769    JP-A- 2001 342 061**
**JP-A- 2002 193 664    JP-A- 2003 026 474**
**JP-A- 2003 034 574**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

### TECHNICAL FIELD

The present invention relates to a piezoelectric ceramic andapiezoelectricelement, for example, apiezoelectricceramic and a piezoelectric element, which are suitable for resonators, ultrasonic transducers, ultrasonic motors and piezoelectric sensors such as an acceleration sensor, a knock sensor, and an AE sensor, and are particularly suitably used as high-frequency resonators of an energy confinement oscillator which is operated by thickness extensional vibration or piezoelectric sensor elements utilizing a positive piezoelectric effect (effect by which electric polarization occurs to generate charges at the surface of a substance in applying stress to the substance).

### BACKGROUND ART

As products utilizing a piezoelectric ceramic, hitherto, there are filters, piezoelectric resonators, ultrasonic transducers (hereinafter, this concept includes an oscillator), ultrasonic motors, piezoelectric sensors, and the like, for example.

In recent years, piezoelectric elements are incorporated into automobile parts such as engines and suspensions and used for combustion control of an engine and posture control of a car body by using a positive piezoelectric effect to sense a pressure applied to the piezoelectric element. Examples of the piezoelectric elements used particularly for engine control include an antiknock sensor in the engine of a lean burn system, which is widely used for the purpose of cleaning the exhaust gas and improving fuel efficiency. Further, use of the piezoelectric element to measure a combustion pressure is studied for the purpose of burning a lean gas stably in an engine of HCCI (Homogeneous Charge Compression Ignition) system expected as a next-generation engine, which does not use combustion plugs.

Since these piezoelectric elements are mounted in an engine room, they require element materials having high heat resistance. Furthermore, in order to improve fuel efficiency, since it is necessary to precisely measure the pressure in an engine cylinder to perform lean burn control finely, element materials, which have less changes in output signal characteristics (pressure characteristic and temperature characteristic of charges generated) of a sensor upon pressure and temperature change, are required.

Conventionally, as a resonator or a pressure sensor element, a PZT (lead zirconate titanate)-based material or a PT (lead titanate)-based material, which has a high piezoelectric property and can obtain, for example, a large P/V (peak-valley value, its definition will be described later) or large charges generated upon application of a pressure, is used. However, it is pointed out that since the PZT-based materials contain lead in an amount of about 60% by mass, these materials are at risk of eluting lead due to acid rain to invite environmental pollution. Thus, high expectations are placed on piezoelectric materials not containing lead.

Further, since the PZT-based material or the PT-based material has a Curie temperature Tc of about 200°C to about 300°C, a piezoelectric coefficient is deteriorated in use under an elevated temperature of about 200°C and the piezoelectric coefficient at 200°C is largely changed relative to the piezoelectric coefficient at room temperature, and therefore there are large constraints on its applications. For example, in the case of being used as a pressure sensor, if the piezoelectric coefficient is deteriorated due to change with time, an output voltage varies even under the same pressure, and if the piezoelectric coefficient at 200°C is largely changed relative to the piezoelectric coefficient at room temperature, it becomes difficult to calculate an accurate pressure from the output voltage because the relationship between the pressure and the output voltage is not linear.

Accordingly, as a piezoelectric ceramic composition not containing lead, a material predominantly composed of a bismuth layered compound is proposed, and it is also proposed to add Mn in order to reduce variations in firing of the bismuth layered compound (for example, Patent Document 1).

Most materials predominantly composed of the bismuth layered compound have a Curie temperature of 400°C or higher, and such a piezoelectric ceramic has high heat resistance and has the potential to be applicable to a sensor element which is used in an environment being exposed to elevated temperatures, for example, in an engine room.

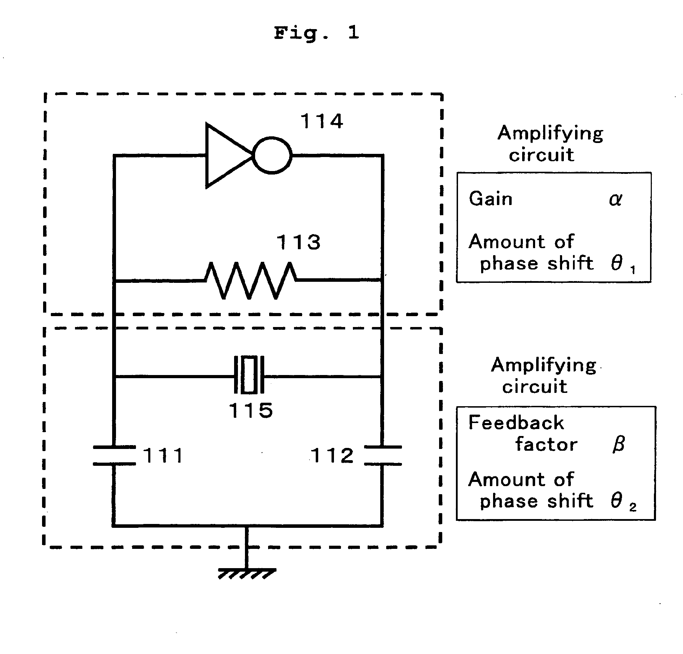

Further, the materials predominantly composed of the bismuth layered compound are characterized by having a relatively high mechanical quality coefficient (Qm) compared with PZT or PT-based materials and have the potential to be applicable to a piezoelectric material for a resonator. The piezoelectric element is used in a reference signal oscillator of a computer as a resonator and incorporated into an oscillator circuit such as a Colpitts oscillator circuit to be used. Fig. 1 is a drawing showing a Pierce oscillator circuit in which a part of inductor is replaced with a piezoelectric resonator in a circuit constitution based on a Colpitts oscillator circuit. The Pierce oscillator circuit is constructed of capacitors 111, 112, resistance 113, an inverter 114 and a resonator 115. In order to generate oscillator signals in the Pierce oscillator circuit, the circuit needs to meet the following oscillating conditions.

That is, when a gain in an amplifying circuit including the inverter 114 and the resistance 113 is denoted by $\alpha$, an amount of phase shift is denoted by $\theta_1$, and a feedback factor in a feedback circuit including the resonator 115 and the capacitors 111, 112 is denoted by $\beta$, and an amount of phase shift is denoted by $\theta_2$, it becomes necessary that a loop gain is $\alpha \times \beta \geq 1$ and an amount of phase shift is $\theta_1 + \theta_2 = 360° \times n$ (n = 1, 2, ...).

Generally, the amplifying circuit including the resistance 113 and the inverter 114 is built into a computer, and the loop gain has to be made large in order to attain stable oscillation without causing error oscillation or non-oscillation. In order to increase the loop gain, it is necessary that P/V of the resonator 115 which determines the gain of the feedback factor $\beta$, that is, a difference between an oscillation impedance $R_o$ and an antioscillation impedance $R_a$, is made large. In addition, P/V is defined as a value of $20 \times \log(R_a/R_o)$.

Patent Document 1: Japanese Unexamined Patent Publication No. 2002-167276

DISCLOSURE OF THE INVENTION

PROBLEMS TO BE SOLVED BY THE INVENTION

However, in the conventional piezoelectric ceramics which do not contain lead and is predominantly composed of the bismuth layered compound, there was a problem that the amount of charges generated is small when being used for a pressure sensor and therefore the piezoelectric ceramic cannot be used as a pressure sensor element requiring high accuracy.

Accordingly, it is an object of the present invention to provide a non-lead piezoelectric ceramic and a non-lead piezoelectric element, which have high piezoelectric characteristics, that is, large spontaneous polarization, or a high piezoelectric coefficient.

Further, in the conventional piezoelectric ceramics which do not contain lead and is predominantly composed of the bismuth layered compound, there was a problem that since the amount of charges generated is small and 15 pC or less per a unit pressure of 1 N when being used for a pressure sensor and a change between charges generated upon temperature change is as large as 20% or more (at 200°C relative to 25°C), the piezoelectric ceramic cannot be used as a pressure sensor element requiring high accuracy.

Accordingly, it is another object of the present invention to provide a non-lead piezoelectric ceramic and a non-lead piezoelectric element, which can increase the amount of charges generated per a pressure of 1 N by a positive piezoelectric effect and are superior in the stability of charges generated upon temperature change from 25°C in a temperature range of -40°C to +200°C.

Further, in the conventional piezoelectric ceramics which do not contain lead and is predominantly composed of the bismuth layered compound, there was a problem that since the amount of charges generated is small and 15 pC or less per a unit pressure of 1 N when being used for a pressure sensor and a change rate of charges generated upon temperature change is as large as 20% or more (at 200°C relative to 25°C), the piezoelectric ceramic cannot be used as a pressure sensor element requiring high accuracy.

Furthermore, when the piezoelectric ceramic is used as a pressure sensor element, there was a problem that since a pressure is applied to the piezoelectric ceramic, mechanical reliability is low under a low relative density. Furthermore, when the piezoelectric ceramic is used as a resonator, for example, in performing element processing such as dicing cut, there was a problem that if the relative density is low, chipping occurs at the processing surface or the edge of the piezoelectric ceramic to cause a ripple.

Accordingly, it is another object of the present invention to provide a non-lead piezoelectric ceramic and a non-lead piezoelectric element, having a high relative density, respectively, which can increase the amount of charges generated per a pressure of 1 N by a positive piezoelectric effect and are superior in the stability of charges generated upon temperature change from 25°C in a temperature range of -40°C to +200°C.

Further, when the piezoelectric ceramic composition described in Patent Document 1 is fired, in the fired piezoelectric ceramic, Mn is intercrystallized in the grains predominantly composed of the bismuth layered compound and Mn is unevenly densely distributed in the grain boundary part of the grains. There was a problem that a portion of the grain boundary part, in which Mn is unevenly densely distributed, also contains a crystal phase, and the crystal phase is deposited between the piezoelectric ceramic and the kiln furniture on which the piezoelectric ceramic is placed during firing and a part of the deposited crystal phase produces a liquid phase and therefore the piezoelectric ceramic is welded to a part of the kiln furniture.

If the piezoelectric ceramic is intensely welded to the kiln furniture on which the piezoelectric ceramic is placed, it is difficult to detach the piezoelectric ceramic from the kiln furniture or cracks or chipping are generated in the piezoelectric ceramic in detaching the piezoelectric ceramic, and therefore, the piezoelectric ceramic becomes defective to be decreased in the yield. Further, the existence of a phase of reaction of the piezoelectric ceramic with the kiln furniture was a factor which deteriorates the piezoelectric characteristics. Furthermore, when the level of the reaction is so low that the piezoelectric characteristics are unaffected and a level of chipping of the piezoelectric ceramic is low, or when a part of the kiln furniture is firmly fixed to the piezoelectric ceramic, chipping or the fixed substance needs to be removed by polishing, which increases the cost.

Accordingly, it is an object of the present invention to provide a piezoelectric ceramic, which is hardly welded to a kiln furniture on which the piezoelectric ceramic is placed during firing, and a piezoelectric element.

Further, in a conventional piezoelectric ceramic not containing lead and predominantly composed of a bismuth layered compound, toughness of the piezoelectric ceramic is low and there was a problem that the piezoelectric ceramic comes into contact with another piezoelectric ceramic or facilities during production and an edge of the piezoelectric ceramic is chipped or a thin piezoelectric ceramic having a thickness of 100 $\mu$m or less is broken.

Furthermore, when the piezoelectric ceramic is used as a pressure sensor element, there was a problem that since a pressure is applied to the piezoelectric ceramic, mechanical reliability is low under a low relative density. Furthermore, when the piezoelectric ceramic is used as a resonator, for example, in performing element processing such as dicing cut, there was a problem that if the relative density is low, chipping occurs at the processing surface or the edge of the piezoelectric ceramic to cause a ripple.

Accordingly, it is another object of the present invention to provide a piezoelectric ceramic and a piezoelectric element, composed of a bismuth layered compound, which are hardly broken by processing.

## MEANS FOR SOLVING THE PROBLEMS

The piezoelectric ceramic and the piezoelectric element of the present invention are as follows.

(1) A piezoelectric ceramic predominantly composed of a bismuth layered compound, containing 100 parts by mass of a component represented by the compositional formula: $Bi_4Ti_3O_{12} \cdot w \{(1-x)A_{1-y-z}Bi_yRE_zTiO_3 \cdot xBiFeO_3\}$, wherein A represents $M1_\alpha(M2_{1/2}Bi_{1/2})_{1-\alpha}$, M1 represents an alkaline earth metal element, M2 represents an alkali metal element, RE represents a rare earth element, and w, x, y, z and $\alpha$ satisfy the following formulae: $1.30 \leq w \leq 1.75$, $0 \leq x \leq 0.10$, $0 \leq y + z \leq 0.30$ and $0 \leq \alpha \leq 1$, and 0.05 part by mass or more of Mn in terms of the content of an oxide ($MnO_2$).

(2) The piezoelectric ceramic according to the paragraph (1), wherein $\alpha = 0$, and the amount of Mn is 2.0 parts by mass or less in terms of the content of an oxide ($MnO_2$).

(3) The piezoelectric ceramic according to the paragraph (1), wherein y = 0, z = 0 and a = 1, M1 represents $(Sr_{1-a}Ca_a)_{1-b}Ba_b$, wherein a and b satisfy the following formulae: $0.40 \leq a \leq 0.60$ and $0 \leq b \leq 0.20$, and the amount of Mn is 1.5 parts by mass or less in terms of the content of an oxide ($MnO_2$).

(4) The piezoelectric ceramic according to the paragraph (3), wherein x satisfies the formula, $0.005 \leq x$.

(5) A piezoelectric ceramic predominantly composed of a bismuth layered compound, wherein the compound is represented by the compositional formula: $Bi_4Ti_3O_{12} \cdot w\{(1-x)ATiO_3 \cdot xBiFeO_3\}$, A represents $M1_\alpha(M2_{1/2}Bi_{1/2})_{1-\alpha}$, M1 represents an alkaline earth metal element, M2 represents an alkali metal element, and w and x satisfy the following formulae: $1.30 \leq w \leq 1.75$ and $0.02 \leq x \leq 0.10$.

(6) The piezoelectric ceramic according to the paragraph (5), wherein $\alpha = 1$, M1 represents $Sr_{1-a}Ca_a$, and a satisfies the formula, $0.40 \leq a \leq 0.60$.

(7) The piezoelectric ceramic according to any one of the paragraphs (1) to (6), wherein the amount of spontaneous polarization is 12 $\mu$C/cm$^2$ or more and the change rate of spontaneous polarization upon temperature change in a range of -40 to +200°C relative to the amount of spontaneous polarization at 25°C is 5% or less.

(8) The piezoelectric ceramic according to the paragraph (1), wherein y satisfies the formula, $0.05 \leq y \leq 0.20$, and the amount of Mn is 2.0 parts by mass or less in terms of the content of an oxide ($MnO_2$).

(9) The piezoelectric ceramic according to the paragraph (1), wherein z satisfies the formula, $0.05 \leq z$, and the amount of Mn is 2.0 parts by mass or less in terms of the content of an oxide ($MnO_2$).

(10) The piezoelectric ceramic according to the paragraph (9), wherein w satisfies the formula: $1.4 \leq w \leq 1.7$.

(11) A piezoelectric ceramic predominantly composed of a bismuth layered compound and containing Mn, wherein Mn is not unevenly densely distributed between grains predominantly composed of the bismuth layered compound, and

containing 100 parts by mass of a main component represented by the compositional formula: $Bi_4Ti_3O_{12} \cdot w(A_{1-z}RE_z)TiO_3$, wherein A represents $M1_\alpha(M2_{1/2}Bi_{1/2})_{1-\alpha}$, M1 represents an alkaline earth metal element, M2 represents an alkali metal element, RE represents a rare earth element, and w, z and $\alpha$ satisfy the following formulae: $0.2 \leq w$, $0.05 \leq z \leq 0.3$ and $0 \leq \alpha \leq 1$, and 0.05 to 2.0 parts by mass of Mn in terms of the content of an oxide ($MnO_2$).

(12) A piezoelectric element including the piezoelectric ceramic according to any one of the paragraphs (1) to (11) and a pair of electrodes opposed to each other with the piezoelectric ceramic sandwiched therebetween.

(13) The piezoelectric element according to the paragraph (12), being operated by thickness extensional vibration.

## EFFECTS OF THE INVENTION

According to the piezoelectric ceramic of the paragraph (1), the spontaneous polarization or the piezoelectric coefficient can be made larger compared with the bismuth layered compound where w = 1, in which the number of layers of the pseudo-perovskite layer is four, and the bismuth layered compound where w = 2, in which the number of pseudo-perovskite layers is five.

Investigations of the bismuth layered compounds in which the value of w is an integer are primarily forging ahead. When the value of w is an integer, if the value of w is large, the number of layers of the pseudo-perovskite layer in a crystal structure of the bismuth layered compound increases and therefore piezoelectric characteristics are thought to be enhanced. However, with the increase in number of layers, the decrease in Curie temperature and the change of charges generated by a positive piezoelectric effect upon temperature change are increased and therefore this bismuth layered compound could not be used for highly precise sensor applications.

The generation of charges by a positive piezoelectric effect results from a dipole present in a crystal and is related to the spontaneous polarization produced by the dipole. When the amount of spontaneous polarization is large, the amount of charges generated is increased. Temperature dependency of the charges generated results from the change of spontaneous polarization upon,temperature change as with the above description. Particularly, when the number of layers of the pseudo-perovskite layer of the bismuth layered compound is an odd number, the spontaneous polarization is produced in a direction of a c-axis. The spontaneous polarization in the direction of a c-axis tends to decrease with changes in temperature. By setting w in a range of $1.30 \leq w \leq 1.75$ like in the piezoelectric ceramic of the paragraph (1), particularly, since the amount of spontaneous polarization becomes larger than that in the case where w is an integer, the amount of charges generated can be increased.

Thereby, characteristics useful for a piezoelectric ceramic used in a high-temperature environment can be attained. Particularly, when the piezoelectric ceramic is used as a piezoelectric ceramic for a pressure sensor, it can be used for nonvolatile ferroelectric memory devices which can be used under elevated temperatures since the degradation of piezoelectric properties is not recognized even in a pressure sensor for directly detecting a pressure in a cylinder of an automobile engine, a shock sensor compatible with SMD (Surface Mount Device), or an elevated temperature of 200°C.

In the case of the piezoelectric ceramic of the paragraph (2), by replacing a bivalent ion of an A site element of the bismuth layered compound with bismuth and an alkali metal element which are bivalent on average, the sinterability of the bismuth layered compound which is hardly sintered is improved and the bismuth layered compound becomes more compact. Therefore, fracture toughness of the ceramic is improved.

In the case of the piezoelectric ceramic of the paragraph (3), changes in the spontaneous polarization upon temperature change can be made small as the spontaneous polarization is increased. Therefore, when w satisfies the formula, $1.30 \leq w \leq 1.75$, the spontaneous polarization along a c-axis is added and the spontaneous polarization becomes larger than that in the case where w is an integer, the change in the spontaneous polarization upon temperature change of the whole crystal can be controlled and the change rate of the spontaneous polarization upon temperature change can be suppressed while increasing the amount of charges generated. Further, by setting the coefficient a in a range of $0.4 \leq$ at 0.60, the amount of spontaneous polarization is increased since the amount of charges generated can be improved while improving the Curie temperature. Therefore, in the piezoelectric ceramic of the present invention, it is possible to increase the amount of charges generated per an applied pressure of 1 N and to decrease the change rate of charges generated upon the temperature change.

When w satisfies the formula, $0.005 \leq x$, like in the piezoelectric ceramic of the paragraph (4), sintering is promoted by the addition of $BiFeO_3$ having a low melting point (1050°C) and the relative density of the piezoelectric ceramic can be increased. Furthermore, by adding or combining a material having a low melting point, the reduction in piezoelectric characteristics, which is common in promoting sintering, is inhibited and the amount of charges generated can be increased and the change in the charges generated upon temperature change can be reduced.

According to the piezoelectric ceramic of the paragraph (5), the amount of spontaneous polarization is considerably increased and the relative density of the ceramic can be increased.

In the case of the piezoelectric ceramic of the paragraph (6), the change in the spontaneous polarization upon temperature change becomes small, and therefore the change rate of charges generated upon temperature change can be made small.

In the case of the piezoelectric ceramic of the paragraph (7), stable piezoelectric characteristics can be attained even under elevated temperatures.

The piezoelectric ceramic of the paragraph (8) is preferable since the piezoelectric coefficient $d_{33}$ can be made high.

In the case of the piezoelectric ceramic of the paragraph (9), since Mn is not unevenly densely distributed between grains predominantly composed of the bismuth layered compound, it is possible to prevent the piezoelectric ceramic from being welded to a kiln furniture with which the piezoelectric ceramic is in contact when the piezoelectric ceramic is exposed to elevated temperatures during a firing step of the piezoelectric ceramic.

When w satisfies the formula, $1.4 \leq w \leq 1.7$, like in the piezoelectric ceramic of the paragraph (10), it is possible to obtain a piezoelectric ceramic having a Curie temperature of 230°C or higher and having a large absolute value of the piezoelectric coefficient in which the piezoelectric coefficient $d_{33}$ is 21 pC/N or more.

According to the piezoelectric ceramic of the paragraph (11), it is possible to prevent the piezoelectric ceramic from being welded to a kiln furniture with which the piezoelectric ceramic is in contact when the piezoelectric ceramic is exposed to elevated temperatures during a firing step of the piezoelectric ceramic.

In the case of the piezoelectric ceramic of the paragraph (11), it becomes possible that Mn is hardly unevenly densely distributed in the grain boundary part between grains of the main component.

In the case of the piezoelectric ceramic of the paragraph (11), it is possible to obtain a piezoelectric ceramic having a large absolute vale of the piezoelectric coefficient.

When w satisfies the formula, $1.4 \leq w \leq 1.7$, it is possible to obtain a piezoelectric ceramic having a Curie temperature of 230°C or higher and having a large absolute value of the piezoelectric coefficient in which a piezoelectric coefficient $d_{33}$ is 21 pC/N or more.

According to the piezoelectric element of the paragraph (12), it is possible to attain stable piezoelectric characteristics even under elevated temperatures. Thereby, when the piezoelectric element is used for the pressure sensor utilizing a positive piezoelectric effect, it is possible to increase the amount of charges generated per an applied pressure of 1 N and attain a characteristic being superior in the stability of the amount of charges generated upon temperature change in a temperature range of -40°C to +200°C.

According to a resonator of such a piezoelectric element, for example, in oscillators operated with a thickness-shear fundamental wave vibration, a thickness longitudinal fundamental wave vibration, or a third overtone vibration mode, since P/V is increased, oscillation allowance is enhanced. Further, since a phase-shift distortion larger than 10° is not generated at a frequency between a resonance frequency and an antiresonance frequency, stable oscillation can be attained, oscillation with high precision which is superior in temperature-stability of the oscillating frequency can be attained, and furthermore, a resonator, which suppresses variations in characteristic due to firing variability significantly since the range of a firing temperature is broadened, and is adaptable to a wide frequency range of 2 to 20 MHz, can be obtained.

Furthermore, since the range of firing temperature is broadened, production of a hetero-phase due to firing variability is suppressed, variations in sensitivity of a piezoelectric sensor, or variations in characteristic of P/V can be suppressed, and a high yield can be realized.

As described in the paragraph (13), by operating the piezoelectric element of the present invention by thickness extensional vibration, it is possible to attain a characteristic which is superior in temperature-stability of the oscillating frequency in a temperature range of -20°C to +80°C.

Further, according to the piezoelectric element of the present invention, by disposing a pair of electrodes opposed to each other at the surface of or within the piezoelectric ceramic, the piezoelectric ceramic becomes free of defects resulting from the removal of the piezoelectric ceramic from the kiln furniture after firing and an inexpensive piezoelectric element can be fabricated.

According to the piezoelectric element of the present invention, by providing a pair of electrodes on both surfaces of the piezoelectric ceramic, chipping or cracks hardly occur in the piezoelectric element during a process step and defects resulting from chipping or cracks decrease, and an inexpensive piezoelectric element can be fabricated.

BRIEF DESCRIPTION OF THE DRAWINGS

Fig. 1 is a schematic view showing a Pierce oscillator circuit based on a Colpitts oscillator circuit.
Fig. 2 is a schematic perspective view showing a resonator for 8 MHz which is a piezoelectric element of an embodiment of the present invention.
Fig. 3(a) is a schematic perspective view showing a pressure sensor which is an embodiment of a piezoelectric element of the present invention, and Fig. 3 (b) is a schematic sectional view showing a piezoelectric actuator which is a piezoelectric element of an embodiment of the present invention.

BEST MODE FOR CARRYING OUT THE INVENTION

It is important that a piezoelectric ceramic of the present invention is predominantly composed of a bismuth layered compound, and contains 100 parts by mass of a component represented by the compositional formula: $Bi_4Ti_3O_{12} \cdot w\{(1-x)A_{1-y-z}Bi_yRE_zTiO_3 \cdot xBiFeO_3\}$, wherein A represents $M1_\alpha(M2_{1/2}Bi_{1/2})_{1-\alpha}$, M1 represents an alkaline earth metal element, M2 represents an alkali metal element, RE represents a rare earth element, and w, x, y, z and $\alpha$ satisfy the following formulae: $1.30 \leq w \leq 1.75$, $0 \leq x \leq 0.10$, $0 \leq y + z \leq 0.30$ and $0 \leq \alpha \leq 1$, and 0.05 part by mass or more of Mn in terms of the content of an oxide.

Herein, the reason why w, which is a coefficient, is set in the above-mentioned range will be described.

Investigations of the bismuth layered compound in which the value of w is an integer are primarily forging ahead.

When the value of w is an integer, if the value of w is large, the number of layers of the pseudo-perovskite layer in a crystal structure of the bismuth layered compound increases and therefore piezoelectric characteristics are thought to be enhanced. However, with the increase in number of layers, the decrease in Curie temperature and the change of charges generated by a positive piezoelectric effect upon temperature change are increased and therefore this bismuth layered compound could not be used for highly precise sensor applications.

The generation of charges by a positive piezoelectric effect results from a dipole present in a crystal and is related to the spontaneous polarization produced by the dipole. When the amount of spontaneous polarization is large, the amount of charges generated is increased. Temperature dependency of the charges generated results from the change of spontaneous polarization upon temperature change as with the above description. Particularly, when the number of layers of the pseudo-perovskite layer of the bismuth layered compound is an odd number, the spontaneous polarization is produced in a direction of a c-axis and the spontaneous polarization in the direction of a c-axis tends to decrease with changes in temperature.

Accordingly, by setting w in a range of $1.30 \leq w \leq 1.75$, since the amount of spontaneous polarization becomes larger than that in the case where w is an integer, the amount of charges generated can be increased. Further, when w satisfies the formula, $1.30 \leq w \leq 1.75$, since the spontaneous polarization along a c-axis is added and the spontaneous polarization becomes larger than that in the case where w is an integer, it become easy to control the change in the spontaneous polarization upon temperature change of the whole crystal.

Furthermore, by setting the content of Mn in terms of the content of an oxide at 0.05 part by mass or more with respect to the content of the above main component, even this material system, which is a plate-like crystal, comes to be easily sintered. Accordingly, by the progress of sintering, an increase in an elastic loss can be suppressed and the amount of charges generated upon pressure application can be increased. Further, by setting the content of Mn in terms of the content of an oxide at 1 part by mass or less, the formation of a hetero-phase can be suppressed and the amount of charges generated upon pressure application can be increased. The content of Mn in terms of the content of an oxide can be increased to 1.5 parts by mass, leading to further improvement in the sinterability. If the content of Mn in terms of the content of an oxide is 1.5 parts by mass or more, since the specific volume resistivity is decreased and the piezoelectric ceramic may become unable to polarize, but the content of Mn can also be increased to about 2.0 parts by mass depending on other parameters in the above compositional formula. In this case, the piezoelectric ceramic can be used as long as it does not cause dielectric breakdown in a polarization treatment of about 5 kV/mm.

The content of Mn in terms of the content of an oxide is preferably 0.05 to 1 part by mass, and more preferably 0.3 to 0.6 part by mass in order to increase the amount of charges generated upon pressure application.

Subsequently, the coefficient x will be described. By setting the coefficient x at 0.005 or more, sintering is promoted by $BiFeO_3$ having a low melting point (1050°C) and the relative density of the piezoelectric ceramic can be made 90% or more. Since the relative density of the piezoelectric ceramic is 90% or more, when being used in the pressure sensor, for example, the break of the piezoelectric ceramic due to a mechanical stress can be inhibited. When the amount of $BiFeO_3$ added increases, an insulation property is deteriorated, but an adequate insulation property can be attained in an environmental temperature of 200°C or lower by setting x in a range of 0.1 or less. Further, generally, by adding or combining a material having a low melting point, the reduction in piezoelectric characteristics, which is common in promoting sintering, hardly occurs. Particularly, the value of x of 0.05 or less, in fact, is preferable since the amount of spontaneous polarization is increased because of an increase in the relative density.

Furthermore, by setting the coefficient x at 0. 005 or more, a phase transition of ferroelectric at a Curie temperature Tc occurs rapidly and therefore the degradation of the piezoelectric characteristics at Tc or lower can be made small. In the piezoelectric ceramic, when the temperature is elevated close to Tc, even if the temperature does not reach Tc, a ferroelectric domain becomes easy to move and consequently depolarization is apt to occur. Therefore, the piezoelectric characteristics may be deteriorated even if the temperature is returned to room temperature after the piezoelectric ceramic is exposed to elevated temperatures, but by setting x in the above-mentioned range, the change of the ferroelectric domain is small even if the piezoelectric ceramic is exposed to an elevated temperature of 400°C, and the degradation of the piezoelectric characteristics after the temperature is returned to room temperature can be made small. Specifically, the reduction in the amount of charges generated upon pressure application can be suppressed even when the piezoelectric ceramic is exposed to elevated temperatures.

By setting the coefficient y in a range of $0 \leq y \leq 0.30$, the piezoelectric coefficient $d_{33}$ of the piezoelectric ceramic can be made higher than that in the case of y = 0. In order to increase the piezoelectric coefficient $d_{33}$, it is more preferable that y satisfies the formula, $0.05 \leq y \leq 0.2$.

Subsequently, the coefficient z will be described. Although the details will be described later, in the piezoelectric ceramic containing the bismuth layered compound and Mn, a deposited phase containing Mn welds the piezoelectric ceramic to a kiln furniture, in some cases. In such a piezoelectric ceramic, when a rare earth element is added, Mn is hardly unevenly densely distributed in the grain boundary part between grains of the bismuth layered compound and it is possible to prevent the deposited phase containing Mn from welding the piezoelectric ceramic to a kiln furniture. The reason why Mn is hardly unevenly densely distributed in the grain boundary part is not clear, it is thought that when a bivalent element in the bismuth layered compound is replaced with a trivalent rare earth element to form a lattice defect, Mn which can have various valences easily enters the defect and therefore intercrystallization of Mn into grains of the bismuth layered compound is promoted and Mn hardly remains in the grain boundary part.

When $z \geq 0.05$, since the amount of a rare earth element substituted is sufficient for intercrystallizing Mn in the bismuth layered compound, Mn is hardly unevenly densely distributed in the grain boundary part. If $z < 0.05$, since the amount of a rare earth element substituted is not sufficient for intercrystallizing Mn in the bismuth layered compound, Mn is unevenly densely distributed in the grain boundary. When $z \leq 0.3$, the bismuth layered compound becomes a piezoelectric ceramic. If $y > 0.3$, the piezoelectric characteristics are very low and the bismuth layered compound is just a dielectric ceramic.

As is shown in the form of $A_{1-y-z}Bi_yRE_z$ in the compositional formula, coefficients y and z are thought to be proportions of replacing primarily elements in the A site of the pseudo-perovskite layer. As described above, when y = 0, the piezoelectric ceramic is applicable when $z \leq 0.3$, and when z = 0, the piezoelectric ceramic is applicable if $y \leq 0.3$. In other words, if 30% or more of the A site elements are replaced, it is thought that the degradation of characteristics as a piezoelectric ceramic becomes remarkable, and therefore the sum of y and z, which are substitution ratios, is preferably 0.3, that is, $0 \leq x + y \leq 0.3$.

Subsequently, the coefficient $\alpha$ will be described. In the bismuth layered compound, when the value of w is an integer, if the value of w is large, the number of layers of the pseudo-perovskite layer in a crystal structure of the bismuth layered compound increases and therefore piezoelectric characteristics are thought to be enhanced. However, with the increase in the number of layers, the bismuth layered compound tended to be hardly sintered. If the firing temperature is increased, the piezoelectric characteristics can undergo a change due to evaporation of bismuth or the composition variation of the piezoelectric ceramic by a reaction of the piezoelectric ceramic with a kiln furniture, and even if the firing temperature is increased, improvements in the yield of a polishing step of the piezoelectric ceramic or improvements in the yield of the preparation of a thin layer piezoelectric ceramic are not sufficient.

Accordingly, by replacing a bivalent ion of an A site element of the bismuth layered compound with bismuth and an alkali metal element which are bivalent on average, the sinterability of the bismuth layered compound which is hardly sintered is improved and the bismuth layered compound becomes more compact. It is thought that the sinterability is improved because the alkali metal element is easily diffused during firing.

This corresponds to reducing the value of $\alpha$ when the compound is represented by the compositional formula: $Bi_4Ti_3O_{12} \cdot w\{(1-x)A_{1-y-z}Bi_yRE_zTiO_3 \cdot xBiFeO_3\}$, wherein A represents $M1_\alpha(M2_{1/2}Bi_{1/2})_{1-\alpha}$, M1 represents an alkaline earth metal element and M2 represents an alkali metal element. Since M1 and $(M2_{1/2}Bi_{1/2})$ become respectively a bivalent positive ion on average, the blending rate $\alpha$ can be set at any value between 0 and 1. In order to enhance the sinterability, $\alpha$ is preferably 0.5 or less, more preferably 0.2 or less, and particularly preferably 0.

Subsequently, the coefficient a will be described. By setting the coefficient a in a range of $0.4 \leq a \leq 0.60$, the amount of spontaneous polarization is increased since the amount of charges generated can be improved while improving the Curie temperature. Therefore, in the piezoelectric ceramic of the present invention, the amount of charges generated per an applied pressure of 1 N can be increased and the change rate of charges generated upon temperature change can be reduced. Further, since a is 0.4 or more, the Curie temperature increases and therefore the reduction in the amount of charges generated upon pressure application after heat treatment at an elevated temperature can be suppressed.

Further, by replacing a part of Sr with Ba, the sinterability is improved and a compact sintered body can be obtained at a lower temperature. When b is increased, the amount of charges generated is increased. However, when b is increased, the change of the amount of spontaneous polarization upon temperature change is increased, and therefore, b is preferably 0.20 or less. Further, when b is increased, the Curie temperature is lowered. In order to decrease the change of the amount of spontaneous polarization upon temperature change and to increase the Curie temperature, a more preferable range of b is $0 \leq b \leq 0.10$. It is particularly preferable to set b at 0. Furthermore, because the spontaneous polarization produced by the dipole existing in a crystal is related to the charges by the positive piezoelectric effect generated due to the dipole, when the amount of spontaneous polarization is large, the amount of charges generated is also increased. In the ceramic of the present invention, since the amount of spontaneous polarization is 13 to 22 $\mu C/cm^2$ and the change rate of spontaneous polarization upon temperature change in a range of -40 to 200°C relative to the spontaneous polarization at 25°C is 5% or less, the spontaneous polarization has low temperature dependency and high charges generated by a positive piezoelectric effect can be obtained.

Further, the piezoelectric ceramic of the present invention is preferably a piezoelectric ceramic predominantly composed of a bismuth layered compound and containing Mn, wherein it is preferable that Mn is not unevenly densely distributed in a grain boundary part between grains predominantly composed of the bismuth layered compound. Thereby, it is possible to prevent the piezoelectric ceramic from being welded to a kiln furniture with which the piezoelectric ceramic is in contact when the piezoelectric ceramic is exposed to elevated temperatures during a firing step of the piezoelectric ceramic.

Herein, the description that Mn is not unevenly densely distributed in a grain boundary means that Mn is not unevenly densely distributed in a grain boundary in Mn element mapping in which a cross section of the piezoelectric ceramic is mirror finished and the cross section was observed at a magnification of 5000 times by EPMA (Electron Probe Micro-Analysis) of an electron microscope to obtain a Mn element map, that is, that the amount of Mn in the grain boundary part is not large when the amount of Mn in the grain of the bismuth layered compound is compared with that in the grain boundary part.

Further specifically, the description that Mn is not unevenly densely distributed in a grain boundary indicates a state in which the average of Mn concentrations (number of counts) in a part other than the grain of the bismuth layered compound is not higher than the average of Mn concentrations within the grain of the bismuth layered compound when sections to which Mn element mapping by EPMA is performed are observed by SEM (Scanning Electron Microscope). Such a state includes the following state. The concentration of Mn is nearly uniform. The average of Mn concentrations (number of counts) in a part other than the grain of the bismuth layered compound is lower than the average of Mn concentrations within the grain of the bismuth layered compound.

Conversely, the description that Mn is unevenly densely distributed in a grain boundary part is a state in which the average of Mn concentrations (number of counts) in a part other than the grain of the bismuth layered compound is higher than the average of Mn concentrations within the grain of the bismuth layered compound. Particularly, when the average of Mn concentrations (number of counts) in a part other than the grain of the bismuth layered compound is 1.5 times or more the average of Mn concentrations within the grain of the bismuth layered compound, or when a triple point of a grain boundary has a Mn concentration two times or more the average of Mn concentrations within the grain of the bismuth layered compound, Mn is extremely unevenly densely distributed in a grain boundary part and the piezoelectric ceramic is heavily welded to a kiln furniture. Further, if this part where the Mn concentration is high is observed with TEM (Transmission Electron Microscope), it is possible to identify by electron beam diffraction that a crystal phase exists.

Since the bismuth layered compound has a plate-like crystal structure and, generally, its sintered density hardly becomes high, the compound is fired after adding a material serving as a sintering aid. Examples of such a material include Mn. Examples of a material of a kiln furniture used in firing a compact of a raw material of the bismuth layered compound include stabilized zirconia (including partially stabilized zirconia), high-purityalumina, spinel, and ceramics such as bismuth layered compounds having the composition identical to or nearly equal to that of the bismuth layered compound to be fired.

When a piezoelectric ceramic predominantly composed of the bismuth layered compound and containing Mn is placed on the above-mentioned ceramic kiln furniture and fired, sometimes, the piezoelectric ceramic is welded to the kiln furniture. When a face where the piezoelectric ceramic is in contact with the kiln furniture was observed in detail and analyzed, consequently, the substance attached to the kiln furniture was not a main phase of the bismuth layered compound but a deposited phase containing much Mn. A phase similar to the deposited phase containing much Mn is also present between the main phases of the bismuth layered compound within the piezoelectric ceramic, and Mn enhances the sinterability of the bismuth layered compound, but it produces a liquid phase containing Mn during firing to cause the piezoelectric ceramic to be welded to a kiln furniture. By suppressing uneven dense distribution of Mn in the grain boundary part, it is possible to prevent the piezoelectric ceramic from being welded to a kiln furniture.

When the piezoelectric ceramic is welded to a kiln furniture, cracks or chipping may occur in removing the piezoelectric ceramic from the kiln furniture. When degrees of these defects are high, the piezoelectric ceramic becomes defective and the yield is deteriorated. When degrees of these defects are low, it is necessary to remove the sections where cracks or chipping are generated by polishing. In the piezoelectric ceramic around the location where the piezoelectric ceramic is welded to a kiln furniture, a magnetic characteristic may be changed by a reaction with the kiln furniture. There may be cases where the removal of the reacted location is necessary. However, by suppressing uneven dense distribution of Mn in the grain boundary part, the piezoelectric ceramic can be used without performing such polishing.

Further, since the bismuth layered compound is a relatively brittle material, failures such as chipping is easily produced by polishing itself, and it is preferable that the piezoelectric ceramic can be used without performing polishing after firing since the reliability of the piezoelectric ceramic is improved. Particularly, when the piezoelectric element is used for applications such as a pressure sensor in which a large pressure is applied to the piezoelectric element, since there are no fine chipping or cracks produced during polishing, failures resulting from these chipping or cracks does not occur and therefore it is preferable.

Further, the piezoelectric ceramic of the present invention contains 100 parts by mass of a main component having the compositional formula represented by $Bi_4Ti_3O_{12} \cdot w(A_{1-z}RE_z)TiO_3$, wherein A represents $M1_\alpha(M2_{1/2}Bi_{1/2})_{1-\alpha}$, M1 represents an alkaline earth metal element, M2 represents an alkali metal element, RE represents a rare earth element, and w, z and $\alpha$ satisfy the following formulae: $1.4 \leq w \leq 1.7$, $0.05 \leq z \leq 0.3$ and $0 \leq \alpha \leq 1$, and 0.05 to 2.0 parts by mass of Mn in terms of the content of $MnO_2$. In such a piezoelectric ceramic, Mn is hardly unevenly densely distributed in the grain boundary part between grains of the bismuth layered compound and it is possible to prevent the deposited phase containing Mn from welding the piezoelectric ceramic to a kiln furniture. The reason why Mn is hardly unevenly densely distributed in the grain boundary part is not clear, but it is thought that when a bivalent element in the bismuth layered compound is replaced with a trivalent rare earth element to form a lattice defect, Mn which can have various valences easily enters the defect and therefore intercrystallization of Mn into grains of the bismuth layered compound is promoted and Mn hardly remains in the grain boundary part.

Here, when w falls within the range as defined in claim 11, since a crystal structure is changed from a crystal structure in which the number of layers of the pseudo-perovskite layer is three and an insulation property is deteriorated to a crystal structure including four or more pseudo-perovskite layers, an insulation property of the piezoelectric ceramic is improved.

Further, when $z \geq 0.05$, since the amount of a rare earth element substituted is sufficient for intercrystallizing Mn in the bismuth layered compound, Mn is hardly unevenly densely distributed in the grain boundary part. If $z < 0.05$, since the amount of a rare earth element substituted is not sufficient for intercrystallizing Mn in the bismuth layered compound, Mn is unevenly densely distributed in the grain boundary. When $z \leq 0.3$, the bismuth layered compound becomes a piezoelectric ceramic. If $y > 0.3$, the piezoelectric characteristics are very low and the bismuth layered compound is just a dielectric ceramic.

Further, since an insulation property of the piezoelectric ceramic is deteriorated if the amount of Mn added is increased, it is estimated that the amount of Mn added is 2 parts by mass or less in terms of the content of $MnO_2$ with respect to 100 parts by mass of the bismuth layered compound as a main component, and Mn in such an amount is not deposited in the grain boundary part of the bismuth layered compound and is mainly intercrystallized in the bismuth layered compound if $1.4 \leq w \leq 1.7$ and $y \geq 0.05$.

A compound used as A may be one having a formula, $M1_{\alpha}(M2_{1/2}Bi_{1/2})_{1-\alpha}$ $(0 \leq \alpha \leq 1)$. That is, A may be M1 alone, $(M2_{1/2}Bi_{1/2})$ alone or any combination thereof. By using M2 in a quantity equal to that of Bi, these act as a bivalent ion on average. Therefore, when a mixture of M1 and $(M2_{1/2}Bi_{1/2})$ is used as A, the proportions of M1 and $(M2_{1/2}Bi_{1/2})$ may be arbitrary.

In the above compositional formula, by containing 0.05 to 2.0 parts by mass of Mn in terms of the content of $MnO_2$ with respect to 100 parts by mass of the main component in which the coefficient satisfies the formula, $1.4 \leq w \leq 1.7$, a piezoelectric ceramic having a large absolute value of the piezoelectric coefficient can be obtained. The reason for this is that by setting w in the above-mentioned range, in the bismuth layered compound, when the number of layers of the pseudo-perovskite layer of the bismuth layered compound is an odd number, a polarization axis is produced in a direction of a c-axis of a crystal lattice of the pseudo-perovskite layer. In the case of the composition in which the number of layers of the pseudo-perovskite layer is not an integer, the amount of polarization is increased and the amount of polarization is particularly increased in the vicinity of the composition where $1.4 \leq w \leq 1.7$. Therefore, by setting w in the above-mentioned range, the pseudo-perovskite layer of the bismuth layered compound can be brought into a state in which the amount of polarization is large.

The above-mentioned increase in the amount of polarization is exhibited by the distortion of a crystal in a part, which is adjacent to $Bi_2O_2$, of the pseudo-perovskite layers, and it is thought that at least 1 to 3 layers of pseudo-perovskite layers adjacent to $Bi_2O_2$ are distorted due to $Bi_2O_2$. When n is increased, a part, which is apart from $Bi_2O_2$, of the pseudo-perovskite layers is increased, and magnetic characteristics of the part is thought to approach characteristics of a ceramic having a normal perovskite structure. However, when n is 7 or less, furthermore n is 5 or less, and particularly n is 3 or less, an effect of a part containing the distorted crystal, which is adjacent to $Bi_2O_2$, of the pseudo-perovskite layers is large, and by setting w in a range of $1.4 \leq w \leq 1.7$, particularly, the amount of polarization can be increased.

In the bismuth layered compound, the Curie temperature is lowered as the value of w is increased. From the viewpoint of only the value of the piezoelectric coefficient, if the value of w becomes large, the proportion of the pseudo-perovskite layer increases and therefore the value of the piezoelectric coefficient tends to increase. However, in the piezoelectric ceramic to be used in a high-temperature environment, it is necessary to make the Curie temperature high and preferable is a bismuth layered compound, in which an absolute value of the piezoelectric coefficient is large at a w value at which the Curie temperature is not more than required and w satisfies the formula, $1.4 \leq w \leq 1.7$. The Curie temperature of the bismuth layered compound varies depending on a material to be added, and if w is 1 to 2, the Curie temperature is about 500 to 300°C.

In the range of $1.4 \leq w \leq 1.7$, since the Curie temperature is 300°C or higher and the bismuth layered compound comes into a state in which a pseudo-perovskite layer having the number of layers of four and a pseudo-perovskite layer having the number of layers of five principally coexist, as described above, an absolute value of the piezoelectric coefficient is increased and the piezoelectric coefficient $d_{33}$ can be increased to 21 pC/N or more.

In summary, when the piezoelectric ceramic contains 100 parts by mass of the bismuth layered compound as a main component, having the compositional formula represented by $Bi_4Ti_3O_{12} \cdot w\{(Sr_{1-a}Ca_a)_{1-b}Ba_bTiO_3\}$, wherein w, a, and b satisfy the following formulae: $1.30 \leq w \leq 1.75$, $0.40 \leq a \leq 0.60$ and $0 \leq b \leq 0.20$, and 0.05 to 1.5 parts by mass of Mn in terms of the content of an oxide, the amount of charges generated upon pressure application does not become less than 18 pC/N.

Further, when the piezoelectric ceramic contains 100 parts by mass of a bismuth layered compound, as a main component, wherein the compound is represented by the compositional formula: $Bi_4Ti_3O_{12} \cdot w\{(1-$

x)(Sr$_{1-a}$Ca$_a$)$_{1-b}$Ba$_b$TiO$_3$·xBiFeO$_3$}, x, y and a satisfy the following formulae: $1.3 \leq x \leq 1.75$, $0.005 \leq y \leq 0.1$ and $0.4 \leq a \leq 0.6$, and 0.05 to 2.0 parts by mass of Mn in terms of the content of an oxide, the amount of spontaneous polarization is increased significantly and the relative ceramic density can be increased.

Further, when the piezoelectric ceramic contains 100 parts by mass of a main component represented by the compositional formula: Bi$_4$Ti$_3$O$_{12}$·w{(M2$_{1/2}$Bi$_{1/2}$)$_{1-y}$Bi$_y$TiO$_3$}, whereinM2 represents an alkali metal element and w and y satisfy the following formulae : $1.4 \leq w \leq 1.7$ and $0 \leq y \leq 0.3$, and 0.05 to 2.0 parts by mass of Mn in terms of the content of an oxide, since the sinterability is enhanced, the piezoelectric ceramic can be hardly broken in processing. In the piezoelectric ceramic of the present invention, the main component is represented by the compositional formula: Bi$_4$Ti$_3$O$_{12}$.w{(1-x)(A$_{1-y-z}$Bi$_y$RE$_z$TiO$_3$)·xBiFeO$_3$}. It is thought that this compound is basically a compound formed by replacing a part of A constituting the pseudo-perovskite layer of the bismuth layered compound represented by Bi$_4$Ti$_3$O$_{12}$·wATiO$_3$ with Bi and RE, and by replacing a part of Ti with Fe. Further, Bi$_4$Ti$_3$O$_{12}$·wATiO$_3$ of A can be described as A$_x$Bi$_4$Ti$_{3+w}$O$_{12+3w}$, and it is thought that the bismuth layered compound is a bismuth layered compound in which structures in the case where m is 4 and in the case where m is 5 coexist with defects in an α site, a β site and an oxygen site in the general formula of the bismuth layered compound represented by (Bi$_2$O$_2$)$^{2+}$(α$_{m-1}$β$_m$O$_{3m+1}$)$^{2-}$ and Mn is partially intercrystallized. Mn may be intercrystallized in the main crystal phase and a part of this may be precipitated in a grain boundary as a crystal of a Mn compound. Further, a pyrochlore phase, a perovskite phase, or a bismuth layered compound having a different structure may exist as another crystal phase, but there is no problem in characteristics as long as the amount of this crystal phase is trace.

In the present invention, the piezoelectric ceramic composed of the bismuth layered compound refers to a piezoelectric ceramic in which a cross section is observed at a magnification of 2000 times by SEM (Scanning Electron Microscope), grains of the bismuth layered compound are identified and grains of the bismuth layered compound makes up 90% or more of the observed area.

Zr or the like from ZrO$_2$ balls used in pulverization may be mixed in the piezoelectric ceramic of the present invention, but there is no problem in characteristics as long as the amount of Zr is trace.

In the piezoelectric ceramic having the composition of the present invention, as a raw material, for example, various oxides including M1CO$_3$ (M1 is an alkaline earth metal element: Sr, Ca, Ba), M2$_2$CO$_3$ (M2 is an alkali metal element: Li, K, Na), Bi$_2$O$_3$, MnO$_2$, TiO$_2$, Fe$_2$O$_3$ and RE$_2$O$_3$ (RE is a rare earth element: La, Tb, Sm, Dz, Z, Gd, Nd, Er, Zb, Lu, Eu), or a salt thereof can be used. The raw material is not limited to these compounds and a metal salt such as a carbonate salt or a nitrate salt, which produces an oxide through firing, may also be used.

In order to prevent the piezoelectric ceramic from being welded to a kiln furniture, as a raw material containing Mn, a powder having an average grain size distribution (D$_{50}$) of 1 μm or less is preferably used. D$_{90}$ is preferably 2 μm or less. The reason for this is that in the case of a raw material powder containing Mn having a large grain size, Mn cannot be adequately diffused and intercrystallized circumferentially throughout the steps of calcining a raw material and firing the piezoelectric ceramic to be described later, and sites in which the content of the Mn component is high is generated and these sites may become a crystal phase containing Mn. In order to further suppress uneven dense distribution of Mn, a raw material containing Mn more preferably has an average grain size distribution of 0.8 μm or less. Further, since when pulverizing MnO$_2$, the pulverized powder tends to have a large particle size, MnCO$_3$ is preferably used as a material containing Mn.

These raw materials are weighed out so as to have the above-mentioned composition, and the raw materials weighed are pulverized so that the mean particle size distribution (D$_{50}$) after being mixed falls within a range of 0.3 to 1 μm and this mixture is calcined at 850 to 1000°C, and the calcined mixture is pulverized so that the mean particle size distribution (D$_{50}$) after being calcined falls within a range of 0.3 to 1 μm, and to this mixture, a predetermined organic binder is added and the resulting mixture is wet-mixed and pelletized.

The powder thus obtained is formed into a predetermined shape by publicly known press forming and fired at a temperature of 1000 to 1250°C for 2 to 5 hours in an oxidizing atmosphere such as the atmospheric air to obtain a piezoelectric ceramic having the composition of the present invention.

The piezoelectric ceramic having the composition of the present invention is most suitable for a piezoelectric ceramic for a resonator of a Pierce oscillator circuit, particularly, for a high-frequency resonator utilizing a fundamental wave vibration of a thickness-shear vibration, like a piezoelectric ceramic shown in Fig. 1, but it can also be used for piezoelectric resonators, ultrasonic transducers, ultrasonic motors and piezoelectric sensors such as an acceleration sensor, a knock sensor, and an AE sensor.

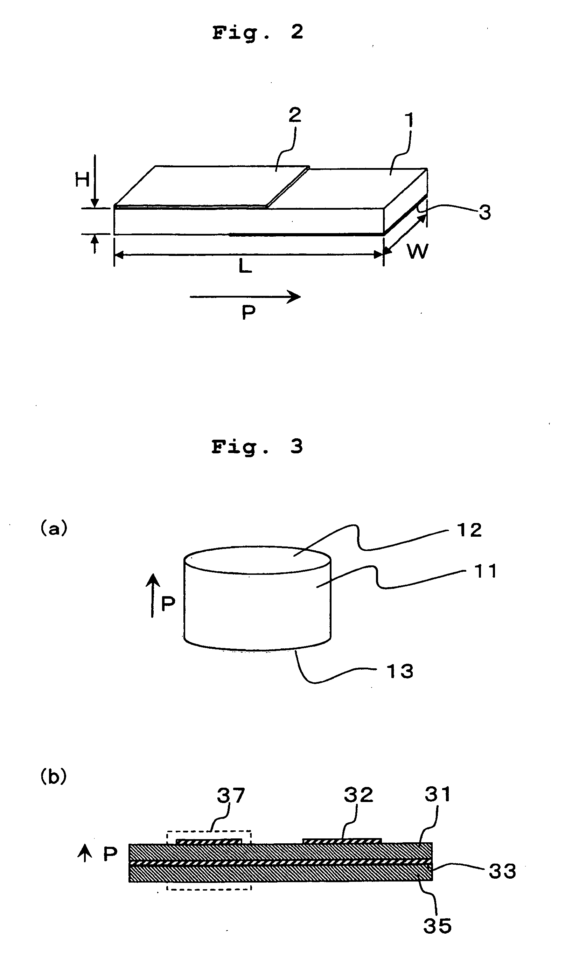

A schematic perspective view of a piezoelectric resonator (piezoelectric oscillator) which is a piezoelectric element of an embodiment of the present invention is shown in Fig. 2. This piezoelectric resonator is constructed by forming electrodes 2, 3 on a pair of opposed principal faces (upper side and under side) of a piezoelectric ceramic 1 having the above composition. In such a piezoelectric resonator, since P/V of a fundamental wave in a thickness-shear vibration and a thickness extensional vibration can be enhanced, oscillation allowance is enhanced and a phase-shift distortion is not generated at frequencies between a resonance frequency and an antiresonance frequency, stable oscillation can be attained. Furthermore, oscillation with high precision which is superior in temperature stability of an oscillating frequency can be attained, and particularly, a piezoelectric resonator, which is adaptable to a frequency range of 2 to 20 MHz, can be obtained.

Further, by employing a piezoelectric ceramic made of a polycrystal, chipping due to processing can be suppressed significantly compared with a single crystal. Furthermore, since the piezoelectric element can be obtained by molding a material into a desired shape with a forming die and firing the molded material, and a phase-shift distortion associated with spurious oscillation is not generated between a resonance frequency and an antiresonance frequency due to chipping (chipping of an edge of a ceramic for a resonator), and it does not satisfy the condition of a phase-shift to cause no miss-oscillation, oscillation with a stable amplitude can be attained.

Accordingly, the above-mentioned piezoelectric resonator does not generate a phase-shift distortion at frequencies between a resonance frequency and an antiresonance frequency and in the neighborhood thereof, and can enhance P/V of a thickness-shear vibration and a thickness extensional vibration, and can be superior in temperature stability of an oscillating frequency in a temperature range of -20°C to +80°C in the thickness extensional vibration. Further, even if the piezoelectric resonator is exposed to an elevated temperature of 400°C, it can retain the same characteristics as those before the exposure to the elevated temperature after being returned to a temperature of -20°C to +80°C and it is a piezoelectric resonator which can be used even in an environment at a high temperature.

A schematic perspective view of a pressure sensor which is an embodiment of a piezoelectric element of the present invention is shown in Fig. 3 (a). This piezoelectric sensor is constructed by forming electrodes 12, 13 on a pair of opposed principal faces (upper side and under side) of a piezoelectric ceramic 11 having the above composition. Further, the piezoelectric ceramic is polarized along a direction perpendicular to the upper side and the under side. In such a pressure sensor, charges are generated at both principal faces by a pressure applied between both principal faces and a pressure applied between principal faces can be measured. Since the piezoelectric ceramic 11 has the above-mentioned composition, it does not exhibit a change of a relationship between an applied pressure and a generated charge in a temperature range of -40°C to +200°C, and retains a relationship between an applied pressure and a generated charge before the exposure to the elevated temperature after being returned to a temperature of -40°C to +200°C even if it is exposed to an elevated temperature such as 400°C, and therefore it is a pressure sensor with high precision which can be used even in an environment at a high temperature. Further, since the relative density of the piezoelectric ceramic is 90% or more, it is a piezoelectric sensor element which is hardly broken by a mechanical stress.

In order to obtain a pressure sensor which can measure stably even in an elevated temperature of 200°C as a pressure sensor element, a method of using a single crystal such as langasite or quartz is also investigated. However, when these single crystals are used, there is a problem that the piezoelectric coefficient is small and chipping easily occurs and the single crystal is easily broken in processing, and furthermore there is a problem that the production cost of the single crystal is extremely high. However, the piezoelectric ceramic of the present invention does not have such problems on processability and can be fabricated inexpensively.

Further, by making the surface of the piezoelectric ceramic rough by firing without polishing the piezoelectric ceramic after firing, such a piezoelectric element can suppress the break due to chipping or cracks produced by polishing even when being used as a piezoelectric sensor to which a pressure of 100 MPa or more is applied.

A longitudinal sectional view of a piezoelectric actuator which is a piezoelectric element of an embodiment of the present invention is shown in Fig. 3 (b). In this piezoelectric actuator, an electrode (individual drive electrode) 32 and an electrode (common electrode) 33 are respectively formed on a pair of opposed principal faces of a piezoelectric ceramic layer 31 made from the piezoelectric ceramic having the above composition, and a vibrating plate 35 is laminated on the principal face, on which the common electrode 33 is formed, of the piezoelectric ceramic layer 31. A plurality of displacement elements 37 are composed of the individual drive electrode 32, the piezoelectric ceramic layer 31, the common electrode 33 and the vibrating plate 35. The polarization of the piezoelectric ceramic layer 31 is applied to the entire piezoelectric ceramic layer 31 or applied to a part sandwiched between the individual drive electrode 32 and the common electrode 33, and if a voltage is applied between the individual drive electrode 32 and the common electrode 33, the piezoelectric ceramic layer 31 is contracted or expanded and the displacement elements 37 are bent by a difference in dimensions between the piezoelectric ceramic layer 31 and the vibrating plate 35 to become an piezoelectric actuator.

The material of the vibrating plate 35 is not particularly limited, but in the piezoelectric ceramic of the present invention, the material is approximately similar to the piezoelectric ceramic layer 31 and a difference in coefficients of thermal expansion between the piezoelectric ceramic layer 31 and the vibrating plate 35 becomes less and less cracks generate, and reliability is improved. Further, since it is possible to fire and prepare the piezoelectric ceramic layer 31, the common electrode 33 and the vibrating plate 35 integrally, the piezoelectric element can be fabricated at low cost.

Next, the piezoelectric ceramic and the piezoelectric element of the present invention will be described by way of examples, but the present invention is not limited to the following examples.

EXAMPLES

First, as starting raw materials, powders of $SrCO_3$, $CaCO_3$, $BaCO_3$, $K_2CO_2$, $Na_2CO_2$, $Bi_2O_3$, $TiO_2$, $Fe_2O_3$ and $RE_2O_3$ (RE represents a rare earth element: La, Tb, Sm, Dz, Z, Gd, Nd, Er, Zb, Lu, Eu), whose purities were 99.9%, were weighed out in such a way that w, x, y, z, a, and b in the main components take the values shown in Tables 1 to 9 and the amount of the $MnO_2$ powder is the values of parts by mass shown in Tables 1 to 9 with respect to 100 parts by mass of the main component when the compositional formula by the molar ratio of the bismuth layered compound is represented by $Bi_4Ti_3O_{12} \cdot w\{(1-x)(A_{1-y-z}Bi_yRE_zTiO_3) \cdot xBiFeO_3\}$, and A represents $M1_\alpha(M2_{1/2}Bi_{1/2})_{1-\alpha}$, M1 represents an alkaline earth metal element, M2 represents an alkali metal element, and RE represents a rare earth element. Here, components not shown in these Tables were not added. For example, in the formulation shown in Table 1, the piezoelectric ceramics in the case where x = 0, y = 0 and z = 0 in the above compositional formula were prepared.

Weighed raw material powders were charged into a 500 ml plastic pot together with zirconia balls 99.9% in purity and ion-exchange water, and mixed for 16 hours with a rotary mill.

The resulting slurry after being mixed was dried in the air and passed through a 40 mesh screen, and thereafter, the screened dried slurry was held at 950°C for 3 hours in the air to be calcined to obtain a synthetic powder. This synthetic powder was charged into a 500 ml plastic pot together with $ZrO_2$ balls 99. 9% in purity and ion-exchange water and pulverized for 20 hours to obtain a powder for evaluation.

To the obtained powder, a proper amount of an organic binder was added, and the resulting mixture was pelletized and the pellets were formed at a pressure of 150 MPa by press using a die, and then the pellets were fired at a temperature of 1050°C to 1250°C for 3 hours in the air to obtain a cylinder-like piezoelectric ceramic for the evaluation of the positive piezoelectric effect of 7 mm in diameter and 2.5 mm in height, a plate-like piezoelectric ceramic for the evaluation of the resonance frequency of 25 mm in length, 38 mm in width and 1 mm in thickness, and a plate-like piezoelectric ceramic for the evaluation of lapping of 25 mm in length, 38 mm in width and 0.5 mm in thickness. Firing was performed with the piezoelectric ceramic placed on a stabilized zirconia kiln furniture.

The piezoelectric ceramic for the evaluation of the positive piezoelectric effect was polished to a thickness of 2 mm, and then Ag electrodes were formed on both principal faces (upper surface and lower surface of the cylindrical piezoelectric ceramic) and a polarization treatment was performed at 7 kV/mm to obtain a piezoelectric element for the evaluation of the positive piezoelectric effect.

A positive piezoelectric effect was evaluated as follows. 300 N of pressure was applied between both principal faces of the above-mentioned piezoelectric element for evaluation as a pre-load, and a pressure of 50 N was applied by a triangle pressure application waveform having a frequency of 10 Hz in addition tothepre-load. Then, an output waveform from the piezoelectric ceramic was detected by a charge amplifier (5011B manufactured by Kistler Corp.) to measure charges generated by the positive piezoelectric effect on pressure application. The amount d (pC/N) of charges generated upon pressure application was calculated by the following formula.

$$d = D/T$$

D: Charges generated (pC)

T: Applied pressure (dynamic range, N)

That is, in the above-mentioned pressure application conditions, the amount d of charges generated was calculated by d = D/50.

Subsequently, the spontaneous polarization (Ps) was evaluated. The above piezoelectric ceramic for the evaluation of the positive piezoelectric effect was polished by lapping to a thickness of 200 pm, and then electrodes were formed on both principal faces (upper surface and lower surface of the cylindrical piezoelectric ceramic) by Au vapor deposition, and the piezoelectric ceramic was cut into a size of 8 mm $\times$ 8 mm with a dicing saw to prepare an evaluation sample. To this sample, a triangle waveform having a frequency of 10 Hz was applied with TF 2000HS manufactured by aixACT AG to measure P-E hysteresis to determine the spontaneous polarization.

Further, the specific volume resistivity was evaluated according to JIS C 2141. The results of the evaluations are shown in Table 1.

[Table 1]

| Sample No. | | Composition | | | | | Spontaneous polarization (Ps) | Amount of charges generated upon pressure application | Change rate of Ps upon temperature change | | Specific volume resistivity | |
|---|---|---|---|---|---|---|---|---|---|---|---|---|
| | | w | A | a | b | Additive amount of $MnO_2$ | | | 25°C →-20°C | 25°C →80°C | 25°C | 200°C |
| | | | | | | parts by mass | $\mu C/cm^2$ | pC/N | % | % | GΩ·m | GΩ·m |
| * | 1 | 1.00 | $(Sr_{1-a}Ca_a)_{1-b}Ba_b$ | 0.50 | - | 0.5 | 7 | 15 | -0.7 | 17 | 117 | 12 |
| | 2 | 1.30 | $(Sr_{1-a}Ca_a)_{1-b}B_{ab}$ | 0.50 | - | 0.5 | 13 | 18 | -0.5 | 10 | 116 | 14 |
| | 3 | 1.35 | $(Sr_{1-a}Ca_a)_{1-b}Ba_b$ | 0.50 | - | 0.5 | 20 | 29 | -0.3 | 5 | 120 | 13 |
| | 4 | 1.50 | $(Sr_{1-a}Ca_a)_{1-b}Ba_b$ | 0.50 | - | 0.5 | 22 | 30 | -0.1 | 0.9 | 120 | 12 |
| | 5 | 1.65 | $(Sr_{1-a}Ca_a)_{1-b}Ba_b$ | 0.50 | - | 0.5 | 17 | 26 | 0.3 | -5 | 117 | 15 |
| | 6 | 1.75 | $(Sr_{1-a}Ca_a)_{1-b}Ba_b$ | 0.50 | - | 0.5 | 17 | 26 | 0.5 | -10 | 120 | 12 |
| * | 7 | 1.95 | $(Sr_{1-a}Ca_a)_{1-b}Ba_b$ | 0.50 | - | 0.5 | 17 | 26 | 0.9 | -40 | 119 | 14 |
| * | 8 | 2.00 | $(Sr_{1-a}Ca_a)_{1-b}Ba_b$ | 0.50 | - | 0.5 | 16 | 24 | 1 | -42 | 117 | 15 |
| | 9 | 1.50 | $(Sr_{1-a}Ca_a)_{1-b}Ba_b$ | 0.10 | - | 0.5 | 7 | 15 | -0.5 | 10 | 118 | 14 |
| | 10 | 1.50 | $(Sr_{1-a}Ca_a)_{1-b}Ba_b$ | 0.35 | - | 0.5 | 14 | 17 | -0.2 | 3 | 119 | 15 |
| | 11 | 1.50 | $(Sr_{1-a}Ca_a)_{1-b}Ba_b$ | 0.40 | - | 0.5 | 20 | 29 | -0.1 | 1 | 118 | 15 |
| | 12 | 1.50 | $(Sr_{1-a}Ca_a)_{1-b}Ba_b$ | 0.60 | - | 0.5 | 20 | 29 | -0.1 | -2 | 119 | 13 |
| | 13 | 1.50 | $(Sr_{1-a}Ca_a)_{1-b}Ba_b$ | 1.00 | - | 0.5 | 8 | 16 | -0.6 | -11 | 117 | 13 |
| * | 14 | 1.50 | $(Sr_{1-a}Ca_a)_{1-b}Ba_b$ | 0.50 | - | - | 10 | 18 | -0.1 | 1 | 117 | 15 |
| | 15 | 1.50 | $(Sr_{1-a}Ca_a)_{1-b}Ba_b$ | 0.50 | - | 0.05 | 15 | 25 | -0.1 | 0.9 | 118 | 15 |
| | 16 | 1.50 | $(Sr_{1-a}Ca_a)_{1-b}Ba_b$ | 0.50 | - | 0.1 | 15 | 25 | -0.1 | 0.9 | 118 | 15 |
| | 17 | 1.50 | $(Sr_{1-a}Ca_a)_{1-b}Ba_b$ | 0.50 | - | 0.3 | 20 | 28 | -0.1 | 1 | 120 | 14 |
| | 18 | 1.50 | $(Sr_{1-a}Ca_a)_{1-b}Ba_b$ | 0.50 | - | 0.6 | 21 | 29 | -0.1 | 0.9 | 117 | 14 |
| | 19 | 1.50 | $(Sr_{1-a}Ca_a)_{1-b}Ba_b$ | 0.50 | - | 0.8 | 17 | 26 | -0.1 | 0.9 | 80 | 3 |
| | 20 | 1.50 | $(Sr_{1-a}Ca_a)_{1-b}Ba_b$ | 0.50 | - | 0.9 | 16 | 24 | -0.2 | 2 | 20 | 1 |
| | 21 | 1.50 | $(Sr_{1-a}Ca_a)_{1-b}Ba_b$ | 0.50 | - | 1.0 | 15 | 18 | -0.2 | 3 | 1 | 0.9 |

EP 2 119 686 B1

(continued)

| Sample No. | | Composition | | | | | Spontaneous polarization (Ps) | Amount of charges generated upon pressure application | Change rate of Ps upon temperature change | | Specific volume resistivity | |
|---|---|---|---|---|---|---|---|---|---|---|---|---|
| | | w | A | a | b | Additive amount of $MnO_2$ | | | $25°C \rightarrow -20°C$ | $25°C \rightarrow 80°C$ | $25°C$ | $200°C$ |
| | | | | | | parts by mass | $\mu C/cm^2$ | pC/N | % | % | $G\Omega \cdot m$ | $G\Omega \cdot m$ |
| | 22 | 1.50 | $(Sr_{1-a}Ca_a)_{1-b}Ba_b$ | 0.50 | - | 1.5 | 15 | 18 | -0.2 | 3 | 0.4 | 0.02 |
| * | 23 | 1.50 | $(Sr_{1-a}Ca_a)_{1-b}Ba_b$ | 0.50 | - | 1.6 | Failed to polarize | | | | 0.3 | 0.01 |
| | 24 | 1.50 | $(Sr_{1-a}Ca_a)_{1-b}Ba_b$ | 0.50 | 0.10 | 0.5 | 23 | 31 | -0.3 | 2 | 118 | 15 |
| | 25 | 1.50 | $(Sr_{1-a}Ca_a)_{1-b}Ba_b$ | 0.50 | 0.20 | 0.5 | 24 | 32 | -0.5 | 4 | 117 | 14 |
| | 26 | 1.50 | $(Sr_{1-a}Ca_a)_{1-b}Ba_b$ | 0.50 | 0.25 | 0.5 | 26 | 34 | -0.7 | 14 | 91 | 2 |
| | 27 | 1.50 | $(Sr_{1-a}Ca_a)_{1-b}Ba_b$ | 0.65 | - | 0.5 | 12 | 17 | -0.3 | -3 | 118 | 13 |

The samples marked "*" are out of the scope of the present invention.

As is apparent from Table 1, in the samples from No. 2 to No. 6, from No. 9 to No. 13, from No. 15 to No. 22, and from No. 24 to No. 27 within the scope of the present invention, when the compound is represented by the compositional formula: $Bi_4Ti_3O_{12} \cdot w\{(1-x)(A_{l-y-z}Bi_yRE_zTiO_3) \cdot xBiFeO_3\}$, wherein A represents $M1_\alpha(M2_{1/2}Bi_{1/2})_{1-\alpha}$, M1 represents an alkaline earth metal element, M2 represents an alkali metal element, RE represents a rare earth element and x, y, z and $\alpha$ satisfy the following formulae: $0 \leq x \leq 0.10$, $0 \leq y + z \leq 0.30$ and $0 \leq \alpha \leq 1$, since w satisfies the formula, $1.30 \leq w \leq 1.75$, the spontaneous polarization can be larger than in a bismuth layered compound, in which A is the same and m = 4 (w = 1) or a bismuth layered compound, in which A is the same and m = 5 (w = 2).

Further, in the samples from No. 2 to No. 6, No. 11, No. 12, from No. 15 to No. 22, No. 24 and No. 25 within the scope of the present invention, since y = 0, z = 0 and $\alpha$ = 1, M1 represents $(Sr_{1-a}Ca_a)_{1-b}Ba_b$, wherein a and b satisfy the following formulae: $0.40 \leq a \leq 0.60$ and $0 \leq b \leq 0.20$, and an amount of Mn is 1.5 parts by mass or less in terms of the content of an oxide ($MnO_2$), values obtained as the amounts of charges generated upon pressure application were as high as 18 pC/N. Further, the change rates between the spontaneous polarization at -40°C or 200°C and the spontaneous polarization at 25°C relative to the spontaneous polarization at 25°C were within $\pm$-10% and the spontaneous polarization had low temperature dependency.

Further, in the samples No. 9, No. 10, No. 13 and No. 27 in which a and b satisfy the formulae, a < 0.4 or 0.6 < a, the amounts of charges generated upon pressure application were as low as 17 pC/N or less.

Further, in the sample No. 26 in which b satisfies the formula, b > 0.2, the change rate of spontaneous polarization upon temperature change was more than 10%, and the spontaneous polarization had high temperature dependency.

On the other hand, as for the samples No. 1, No. 7 and No. 8 in which values of w were out of the scope of the present invention, in the sample No. 1 in which the value of w was small, the change rate of the spontaneous polarization at 200°C relative to the spontaneous polarization at 25°C was larger than 10%, and in the samples No. 7 and No. 8 in which the values of w were large, the change rates of the spontaneous polarization at 200°C relative to the spontaneous polarization at 25°C were larger than -10%, and these spontaneous polarization had high temperature dependency.

Furthermore, in the sample No. 14 in which the amount of $MnO_2$ added is 0, the ceramic did not adequately become compact and the amount of charges generated upon pressure application was as low as 10 pC/N. In the sample No. 23 in which the amount of $MnO_2$ added is 1.6, the ceramic was subjected to a polarization treatment but could not be polarized.

The piezoelectric ceramic for the evaluation of the resonance frequency was processed into a size of 6 mm in length and 30 mm in width, and then end surface electrodes for polarization in a longitudinal direction were formed, and a polarization treatment was performed under the condition of 7 kV/mm. Thereafter, the electrodes for polarization were eliminated and the piezoelectric ceramic was processed so as to be about 0.17 mm in thickness by a lapping machine. Then, Cr-Ag was deposited on both sides of a principal face (face 6 mm in length and 30 mm in width) by vapor deposition. In order to enhance adhesion strength between the electrode and the ceramic, the piezoelectric ceramic was subjected to an annealing treatment at 250°C for 12 hours.

Thereafter, the electrodes were removed by etching to be processed so as to leave an electrode shown in Fig. 2. Furthermore, the piezoelectric ceramic was processed into a plate shape 2.2 mm in length, 0.9 mm in width and 0.17 mm in height with a dicing saw to obtain a small-sized resonator for fundamental wave oscillation of thickness extensional vibration corresponding to 8 MHz oscillation. In Fig. 2, P indicates the direction of polarization.

With respect to characteristics of the resonator, an impedance waveform was measured with an impedance analyzer, and P/V in a fundamental wave oscillation of thickness-shear vibration was calculated from the formula, PV = $20 \times log(R_a/R_o)$ ($R_a$: antioscillation impedance, $R_o$: oscillation impedance).

Furthermore, the change rate of oscillating frequency upon temperature change was determined from the following formula representing a change of the oscillating frequency at -20°C or +80°C relative to the oscillating frequency at 25°C.

$$F_{osc} \text{ change rate} = \{F_{osc}(drift) - F_{osc}(25)\}/F_{osc}(25)$$

In the above formula, $F_{osc}$(drift) represents an oscillating frequency at -20°C or +80°C and $F_{osc}$(25) represents an oscillating frequency at 25°C. The results are shown in Table 2.

[Table 2]

| Sample No. | | Composition | | | | | P/V | Change rates of oscillating frequency upon temperature change | |
|---|---|---|---|---|---|---|---|---|---|
| | | | | | | Additive amount of $MnO_2$ | | 25°C→20°C | 25°C→80°C |
| | | w | A | a | b | parts by mass | dB | ppm | ppm |
| | 3 | 1.35 | $(Sr_{1-a}Ca_a)_{1-b}Ba_b$ | 0.50 | - | 0.5 | 71 | 1600 | -1800 |
| | 4 | 1.50 | $(Sr_{1-a}Ca_a)_{1-b}Ba_b$ | 0.50 | - | 0.5 | 75 | 820 | -912 |
| | 5 | 1.65 | $(Sr_{1-a}Ca_a)_{1-b}Ba_b$ | 0.50 | - | 0.5 | 70 | 1900 | -2000 |
| | 11 | 1.50 | $(Sr_{1-a}Ca_a)_{1-b}Ba_b$ | 0.40 | - | 0.5 | 69 | 1700 | -2000 |
| | 12 | 1.50 | $(Sr_{1-a}Ca_a)_{1-b}Ba_b$ | 0.60 | - | 0.5 | 67 | 1800 | -2090 |
| | 15 | 1.50 | $(Sr_{1-a}Ca_a)_{1-b}Ba_b$ | 0.50 | - | 0.05 | 50 | 900 | -1020 |
| | 22 | 1.50 | $(Sr_{1-a}Ca_a)_{1-b}Ba_b$ | 0.50 | - | 1.5 | 45 | 890 | -992 |
| | 24 | 1.50 | $(Sr_{1-a}Ca_a)_{1-b}Ba_b$ | 0.50 | 0.10 | 0.5 | 65 | 840 | -930 |

The samples marked "*" are out of the scope of the present invention.

It is found from Table 2 that in the samples within the scope of the present invention, P/V of fundamental wave oscillation in thickness-shear vibration can be increased to 45 dB or more, and the change rates of oscillating frequency upon temperature change were as small as within ±2100 ppm.

Further, samples in another group were evaluated and the results are shown in Tables 3 and 4.

The relative ceramic density was determined by dividing a bulk density measured according to JIS R 2205 by a true density. Since the true density is determined by measuring the density of ceramic itself excluding pores in the ceramic, the piezoelectric ceramic was ground to an average particle size of about 3 $\mu$m with a mortar and measured with a pycnometer.

Further, in order to investigate the degradation of piezoelectric characteristics in being exposed to a high-temperature environment, after heat treating the sample at 400°C for 1 hour, the amount of charges generated upon pressure application was measured again in an environment of 25°C, and a reduction rate in charges generated upon pressurizing after heat treatment at an elevated temperature was calculated from the following formula:

The reduction rate in charges generated upon pressurizing after heat treatment at an elevated temperature = (amount of charges generated upon pressure application before heat treatment at an elevated temperature − amount of charges generated upon pressure application after heat treatment at an elevated temperature)/amount of charges generated upon pressure application before heat treatment at an elevated temperature.

Here, the samples in which the reduction rate in charges generated upon pressurizing after heat treatment at an elevated temperature was 0.0% represent that the reduction rate in charges generated upon pressurizing after heat treatment at an elevated temperature was larger than -0.05% in terms of the absolute value and was lower than 0.05%. The results are shown in Table 3.

[Table 3]

| | Sample No. | Composition | | | | | Spontaneous polarization (Ps) | Amount of charges generated upon pressure application | Reduction rate in charges generated upon pressurizing after heat treatment at elevated temperature | Change rate of Ps upon temperature change | | Specific volume resistivity | | Relative ceramic density |
|---|---|---|---|---|---|---|---|---|---|---|---|---|---|---|
| | | w | A | x | a | Additive amount of $MnO_2$ | | | | 25°C →-40°C | 25°C →200°C | 25°C | 200°C | |
| | | | | | | parts by mass | $\mu$ C/cm$^2$ | pC/N | % | % | % | GΩ·m | GΩ·m | % |
| * | 101 | 1.00 | $Sr_{1-a}Ca_a$ | 0.02 | 0.5 | 0.5 | 8 | 17 | 0.0 | -0.1 | 7.6 | 117 | 12 | 97 |
| | 102 | 1.30 | $Sr_{1-a}Ca_a$ | 0.02 | 0.5 | 0.5 | 15 | 20 | 0.0 | -0.6 | 4.4 | 116 | 14 | 98 |
| | 103 | 1.35 | $Sr_{1-a}Ca_a$ | 0.02 | 0.5 | 0.5 | 23 | 32 | 0.0 | -0.4 | 2.2 | 120 | 13 | 98 |
| | 104 | 1.50 | $Sr_{1-a}Ca_a$ | 0.02 | 0.5 | 0.5 | 25 | 33 | 0.0 | -0.1 | 0.4 | 120 | 12 | 99 |
| | 105 | 1.65 | $Sr_{1-a}Ca_a$ | 0.02 | 0.5 | 0.5 | 19 | 29 | 0.0 | 0.3 | -2.2 | 117 | 15 | 98 |
| | 106 | 1.75 | $Sr_{1-a}Ca_a$ | 0.02 | 0.5 | 0.5 | 19 | 29 | 0.0 | 0.5 | -4.4 | 120 | 12 | 98 |
| * | 107 | 1.95 | $Sr_{1-a}Ca_a$ | 0.02 | 0.5 | 0.5 | 19 | 29 | 0.0 | 0.9 | -17.8 | 119 | 14 | 97 |
| * | 108 | 2.00 | $Sr_{1-a.}Ca_a$ | 0.02 | 0.5 | 0.5 | 18 | 26 | 0.0 | 1 | -18.7 | 117 | 15 | 97 |
| | 109 | 1.50 | $Sr_{1-a}Ca_a$ | - | 0.5 | 0.5 | 22 | 30 | 5 | -0.1 | 0.9 | 120 | 12 | 73 |
| | 110 | 1.50 | $Sr_{1-a}Ca_a$ | 0 | 0.5 | 0.5 | 23 | 31 | 2 | -0.1 | 0.8 | 122 | 14 | 85 |
| | 111 | 1.50 | $Sr_{1-a}Ca_a$ | 0.01 | 0.5 | 0.5 | 24 | 32 | 0.0 | -0.1 | 0.6 | 121 | 13 | 92 |
| | 112 | 1.50 | $Sr_{1-a}Ca_a$ | 0.01 | 0.5 | 0.5 | 25 | 33 | 0.0 | 0 | 0.4 | 120 | 12 | 95 |
| | 113 | 1.50 | $Sr_{1-a}Ca_a$ | 0.02 | 0.5 | 0.5 | 25 | 33 | 0.0 | 0 | 0.4 | 120 | 12 | 97 |
| | 114 | 1.50 | $Sr_{1-a}Ca_a$ | 0.05 | 0.5 | 0.5 | 25 | 33 | 0.0 | 0 | 0.4 | 119 | 12 | 98 |
| | 115 | 1.50 | $Sr_{1-a}Ca_a$ | 0.08 | 0.5 | 0.5 | 19 | 28 | 0.0 | -0.1 | 0.4 | 60 | 6 | 99 |
| | 116 | 1.50 | $Sr_{1-a}Ca_a$ | 0.10 | 0.5 | 0.5 | 16 | 24 | 0.0 | -0.1 | 0.4 | 10 | 1 | 98 |
| * | 117 | 1.50 | $Sr_{1-a}Ca_a$ | 0.12 | 0.5 | 0.5 | 12 | 17 | 0.0 | -0.1 | 0.5 | 0.6 | 0.05 | 98 |
| | 118 | 1.50 | $Sr_{1-a}Ca_a$ | 0.02 | 0.1 | 0.5 | 8 | 17 | 14 | -0.5 | 4.4 | 118 | 14 | 98 |
| | 119 | 1.50 | $Sr_{1-a}Ca_a$ | 0.02 | 0.35 | 0.5 | 16 | 19 | 5 | -0.2 | 1.3 | 119 | 15 | 99 |

(continued)

| Sample No. | | Composition | | | | | Spontaneous polarization (Ps) | Amount of charges generated upon pressure application | Reduction rate in charges generated upon pressurizing after heat treatment at elevated temperature | Change rate of Ps upon temperature change | | Specific volume resistivity | | Relative ceramic density |
|---|---|---|---|---|---|---|---|---|---|---|---|---|---|---|
| | | w | A | x | a | Additive amount of MnO$_2$ | | | | 25°C →-40°C | 25°C →200°C | 25°C | 200°C | |
| | | | | | | parts by mass | μC/cm$^2$ | pC/N | % | % | % | GΩ·m | GΩ·m | % |
| 120 | | 1.50 | Sr$_{1-a}$Ca$_a$ | 0.02 | 0.4 | 0.5 | 23 | 32 | 0.0 | -0.1 | 0.4 | 118 | 15 | 98 |
| 121 | | 1.50 | Sr$_{1-a}$Ca$_a$ | 0.02 | 0.6 | 0.5 | 23 | 32 | 0.0 | -0.1 | -0.9 | 119 | 13 | 98 |
| 122 | | 1.50 | Sr$_{1-a}$Ca$_a$ | 0.02 | 1.0 | 0.5 | 9 | 17 | 0.0 | -0.6 | -4.9 | 117 | 13 | 98 |
| 123 | * | 1.50 | Sr$_{1-a}$Ca$_a$ | 0.01 | 0.5 | - | 10 | 18 | 2 | -0.2 | 0.4 | 117 | 15 | 79 |
| 124 | | 1.50 | Sr$_{1-a}$Ca$_a$ | 0.01 | 0.5 | 0.05 | 17 | 28 | 0.0 | -0.2 | 0.4 | 118 | 15 | 93 |
| 125 | | 1.50 | Sr$_{1-a}$Ca$_a$ | 0.01 | 0.5 | 0.1 | 17 | 28 | 0.0 | -0.2 | 0.4 | 118 | 15 | 95 |
| 126 | | 1.50 | Sr$_{1-a}$Ca$_a$ | 0.01 | 0.5 | 0.3 | 23 | 31 | 0.0 | -0.2 | 0.4 | 120 | 14 | 97 |
| 127 | | 1.50 | Sr$_{1-a}$Ca$_a$ | 0.01 | 0.5 | 0.6 | 24 | 32 | 0.0 | -0.2 | 0.4 | 117 | 14 | 98 |
| 128 | | 1.50 | Sr$_{1-a}$Ca$_a$ | 0.01 | 0.5 | 0.8 | 19 | 29 | 0.0 | -0.1 | 0.4 | 80 | 3 | 98 |
| 129 | | 1.50 | Sr$_{1-a}$Ca$_a$ | 0.01 | 0.5 | 0.9 | 18 | 26 | 0.0 | -0.2 | 0.9 | 20 | 1 | 99 |
| 130 | | 1.50 | Sr$_{1-a}$Ca$_a$ | 0.01 | 0.5 | 1.0 | 17 | 20 | 0.0 | -0.3 | 1.3 | 1 | 0.9 | 99 |
| 131 | | 1.50 | Sr$_{1-a}$Ca. | 0.01 | 0.5 | 1.5 | 17 | 20 | 0.0 | -0.2 | 1.3 | 0.4 | 0.02 | 98 |
| 132 | | 1.50 | Sr$_{1-a}$Ca$_a$ | 0.01 | 0.5 | 1.8 | 17 | 20 | 0.0 | -0.2 | 1.3 | 0.4 | 0.02 | 98 |
| 133 | | 1.50 | Sr$_{1-a.}$Ca$_a$ | 0.01 | 0.5 | 2.0 | 17 | 20 | 0.0 | -0.2 | 1.3 | 0.4 | 0.02 | 98 |
| 134 | * | 1.50 | Sr$_{1-a}$Ca$_a$ | 0.01 | 0.5 | 2.2 | Failed to polarize | | | | | 0.3 | 0.01 | 98 |

The samples marked "*" are out of the scope of the present invention.

As is apparent from Table 3, in the samples from No. 102 to No. 106, from No. 109 to No. 116, from No. 118 to No. 122, and from No. 124 to No. 133 within the scope of the present invention, when the compound is represented by the compositional formula: $Bi_4Ti_3O_{12} \cdot w\{(1-x)(A_{1-y-z}Bi_yRE_zTiO_3) \cdot xBiFeO_3\}$, wherein A represents $M1_\alpha(M2_{1/2}Bi_{1/2})_{1-\alpha}$, M1 represents an alkaline earth metal element, M2 represents an alkali metal element, RE represents a rare earth element and x, y, z and $\alpha$ satisfy the following formulae: $0 \leq x \leq 0.10$, $0 \leq y + z \leq 0.30$ and $0 \leq \alpha \leq 1$, w satisfies the formula, $1.30 \leq w \leq 1.75$ and therefore, the spontaneous polarization could be made larger than in a bismuth layered compound, in which A is the same and m = 4 (w = 1) or a bismuth layered compound, in which A is the same and m = 5 (w = 2).

Further, in the samples from No. 102 to No. 106, from No. 111 to No. 116, No. 120, No. 121 and from No. 124 to No. 133 within the scope of the present invention, since x, y, z and $\alpha$ satisfy the following formulae: $0.005 \leq x \leq 0.10$, y = 0, z = 0 and $\alpha = 1$, M1 represents $(Sr_{1-a}Ca_a)_{1-b}Ba_b$, wherein a and b satisfy the following formulae: $0.40 \leq a \leq 0.60$ and $0 \leq b \leq 0.20$, and the amount of Mn is 1.5 parts by mass or less in terms of the content of an oxide ($MnO_2$), values obtained as the amounts of charges generated upon pressure application were as high as 20 pC/N, and the change rates between the spontaneous polarization at -40°C or 200°C and the spontaneous polarization at 25°C relative to the spontaneous polarization at 25°C were within $\pm 5\%$ and these spontaneous polarization had low temperature dependency and the relative ceramic densities were as high as 90% or more. Particularly, the samples in which w satisfy the formula, $1.35 \leq w \leq 1.65$, had the change rate of spontaneous polarization within $\pm 3\%$ and very low temperature dependency.

Further, in the samples No. 109 and No. 110 in which x satisfies the formula, x < 0.005, the relative ceramic densities were as low as less than 90%.

Further, as for the samples No. 118, No. 119 and No. 122 in which a and b satisfy the formulae, a < 0.4 or 0.6 < a, in the samples No. 117 and No. 118 in which the value of a was small, the reductions in the amount of charges generated upon pressure application after heat treatment at an elevated temperature were as large as 5% or more, and in the sample No. 122 in which the value of a was large, the amount of charges generated upon pressure application was as low as 17 pC/N.

On the other hand, as for the samples No. 101, No. 107 and No. 108 in which values of w were out of the scope of the present invention, in the sample No. 101 in which the value of w was small, the change rate of the spontaneous polarization at 200°C relative to the spontaneous polarization at 25°C was larger than 5%, and in the samples No. 107 and No. 108, in which the values of w were large, the change rates between the spontaneous polarization at 200°C and the spontaneous polarization at 25°C relative to the spontaneous polarization at 25°C were larger than -5% in terms of the absolute value, and these spontaneous polarization had high temperature dependency.

Further, in the sample No. 117 out of the scope of the present invention, in which x satisfies the formula, x > 0.10, the specific volume resistivity at 200°C was lower than 1 GΩ·m and the insulation property was low.

In the sample No. 123 in which $MnO_2$ was not added, the relative ceramic density was less than 90% and the ceramic did not adequately become compact. The ceramic of sample No. 134, in which the amount of $MnO_2$ added was 2.2 parts by mass, was subjected to a polarization treatment, but it could not be polarized.

P/V and the change rates of the oscillating frequency upon temperature change of the piezoelectric ceramic for the evaluation of the resonance frequency were measured in the same manner as in the above evaluations. Furthermore, in order to investigate the degradation of piezoelectric characteristics in being exposed to a high-temperature environment, after heat treating the sample at 400°C for 1 hour, P/V was measured again in an environment of 25°C, and the reduction rate in P/V after heat treatment at an elevated temperature was calculated from the following formula:

```
The reduction rate in P/V after heat treatment at an

elevated temperature = (P/V before heat treatment at an elevated

temperature - P/V after heat treatment at an elevated

temperature)/P/V before heat treatment at an elevated

temperature.
```

Here, the samples in which the reduction rate in P/V after heat treatment at an elevated temperature was 0.0% represent that the reduction rate in P/V after heat treatment at an elevated temperature was larger than -0.05% in terms of the absolute value and was lower than 0.05%. The results are shown in Table 4.

[Table 4]

| Sample No. | | Composition | | | | | P/V | Reduction rate in P/V after heat treatment at elevated temperature | Change rates of oscillating frequency upon temperature change | |
|---|---|---|---|---|---|---|---|---|---|---|
| | | w | A | x | a | Additive amount of MnO$_2$ | | | 25°C →-20pC | 25°C →80°C |
| | | | | | | parts by mass | dB | of | ppm | ppm |
| | 102 | 1.35 | Sr$_{1-a}$Ca$_a$ | 0.02 | 0.5 | 0.5 | 71 | 0.0 | 1590 | -1780 |
| | 103 | 1.50 | Sr$_{1-a}$Ca$_a$ | 0.02 | 0.5 | 0.5 | 75 | 0.0 | 819 | -898 |
| | 104 | 1.65 | Sr$_{1-a}$Ca$_a$ | 0.02 | 0.5 | 0.5 | 70 | 0.0 | 1890 | -1990 |
| | 105 | 1.50 | Sr$_{1-a}$Ca$_a$ | 0.02 | 0.4 | 0.5 | 69 | 0.0 | 1680 | -1990 |
| | 106 | 1.50 | Sr$_{1-a}$Ca$_a$ | 0.02 | 0.6 | 0.5 | 67 | 0.0 | 1790 | -2080 |
| | 110 | 1.50 | Sr$_{1-a}$Ca$_a$ | - | 0.5 | 0.5 | 75 | 5.0 | 820 | -912 |
| | 111 | 1.50 | Sr$_{1-a}$Ca$_a$ | 0.0025 | 0.5 | 0.5 | 76 | 0.0 | 819 | -898 |
| | 112 | 1.50 | Sr$_{1-a}$Ca$_a$ | 0.005 | 0.5 | 0.5 | 77 | 0.0 | 818 | -897 |
| | 113 | 1.50 | Sr$_{1-a}$Ca$_a$ | 0.02 | 0.5 | 0.5 | 77 | 0.0 | 819 | -895 |
| | 116 | 1.50 | Sr$_{1-a}$Ca$_a$ | 0.10 | 0.5 | 0.5 | 69 | 0.0 | 818 | -896 |
| * | 117 | 1.50 | Sr$_{1-a}$Ca$_a$ | 0.12 | 0.5 | 0.5 | 54 | 0.0 | 817 | -895 |
| | 123 | 1.50 | Sr$_{1-a}$Ca$_a$ | 0.01 | 0.5 | 0.05 | 50 | 0.0 | 898 | -1008 |
| | 133 | 1.50 | Sr$_{1-a}$Ca$_a$ | 0.01 | 0.5 | 2.0 | 45 | 0.0 | 880 | -999 |
| The samples marked "*" are out of the scope of the present invention. | | | | | | | | | | |

It is found from Table 4 that in the samples within the scope of the present invention, P/V of fundamental wave oscillation in thickness-shear vibration can be increased to 45 dB or more, and the change rates of the oscillating frequency upon temperature change were as small as within ±2100 ppm.
Further, samples in another group were evaluated in the same manner as in the above evaluations and the results are shown in Tables 5 and 6.

[Table 5]

| | Sample No. | Composition | | | | Spontaneous polarization (Ps) | Amount of charges generated upon pressure application | Reduction rate in charges generated upon pressurizing after heat treatment at elevated temperature | Change rate of amount of Ps upon temperature change | | Specific volume resistivity | | Relative ceramic density |
|---|---|---|---|---|---|---|---|---|---|---|---|---|---|
| | | w | A | x | a | | | | $25°C \rightarrow -40°C$ | $25°C \rightarrow 200°C$ | $25°C$ | $200°C$ | |
| | | | | | | $\mu C/cm^2$ | pC/N | % | % | % | $G\Omega·m$ | $G\Omega·m$ | % |
| * | 135 | 1.50 | $Sr_{1-a}Ca_a$ | 0 | 0.5 | 10 | 18 | 5 | -0.1 | 1.0 | 117 | 15 | 72 |
| | 136 | 1.50 | $Sr_{1-a}Ca_a$ | 0.02 | 0.5 | 12 | 20 | 0.0 | -0.2 | 0.4 | 117 | 15 | 91 |
| | 137 | 1.50 | $Sr_{1-a}Ca_a$ | 0.05 | 0.5 | 12 | 20 | 0.0 | 0 | 0.4 | 116 | 11 | 93 |
| | 138 | 1.50 | $Sr_{1-a}Ca_a$ | 0.08 | 0.5 | 9 | 19 | 0.0 | -0.1 | 0.4 | 58 | 6 | 98 |
| | 139 | 1.50 | $Sr_{1-a}Ca_a$ | 0.1 | 0.5 | 7 | 18 | 0.0 | -0.1 | 0.4 | 9 | 2 | 99 |
| * | 140 | 1.50 | $Sr_{1-a}Ca_a$ | 0.12 | 0.5 | 5 | 10 | 0.0 | -0.1 | 0.5 | 0.6 | 0.05 | 98 |

The samples marked "*" are out of the scope of the present invention.

[Table 6]

| Sample No. | | Composition | | | | P/V | Reduction rate in P/V after heat treatment at elevated temperature | Change rates of oscillating frequency upon temperature change | |
|---|---|---|---|---|---|---|---|---|---|
| | | w | A | x | a | | | 25°C →-20°C | 25°C →80°C |
| | | | | | | dB | % | ppm | ppm |
| | 136 | 1.50 | $Sr_{1-a}Ca_a$ | 0.02 | 0.5 | 67 | 0.0 | 894 | -1009 |
| | 139 | 1.50 | $Sr_{1-a}Ca_a$ | 0.10 | 0.5 | 66 | 0.0 | 881 | -998 |
| The samples marked "*" are out of the scope of the present invention. | | | | | | | | | |

It is found from Table 5 that in the evaluations of the piezoelectric ceramic for the evaluation of the positive piezoelectric effect, in the samples No. 135 in which the value of x was small and No. 123 in which $MnO_2$ was not added in Table 3, the relative ceramic densities were less than 90% and the ceramics did not adequately become compact. Further, in the sample No. 117 in which the value of x was large, the specific volume resistivity at 200°C was lower than 1 GΩ·m and the insulation property was low.

It is found from Table 6 that in the samples within the scope of the present invention, P/V of fundamental wave oscillation in thickness-shear vibration can be increased to 65 dB or more, and the change rates of the oscillating frequency upon temperature change were as small as within ±1100 ppm.

Further, samples in another group were evaluated and the results are shown in Tables 7 and 8.

With respect to welding to a kiln furniture, the sample, in which one or more of 30 pieces of the piezoelectric ceramic were welded to a kiln furniture during firing, was represented as "yes" in attachment to a kiln furniture.

A Mn element map prepared by mirror polishing a cross section of the piezoelectric ceramic, and observing the cross section at a magnification of 5000 times by EPMA of an electron microscope was superimposed on a SEM image, and comparisons between the inside of the grain of the bismuth layered compound and the grain boundary part in the SEM image were made in the elementmap, and the case where many Mns exist in the grain boundary part, that is, a site where the number of counts of the element is high is contained in the grain boundary part, was represented as "yes" in Mn unevenly densely distributed in the grain boundary part (Mn is unevenly densely distributed in the grain boundary part). The site where the number of counts of the element is high was mainly observed at the triple point of the grain boundary of the bismuth layered compound.

As for the Curie temperature, the piezoelectric element for the evaluation of the positive piezoelectric effect was placed in a thermostat, an electrostatic capacity of the element was measured at various temperatures, and the temperature at which the electrostatic capacity was maximum and largest was taken as the Curie temperature. These results are shown in Table 7.

[Table 7]

| Sample No. | | Composition | | | | | Uneven dense distribution of Mn | Welding to firing jig | piezoelectric coefficient d33 | Specific volume resistivity | Curie temperature |
|---|---|---|---|---|---|---|---|---|---|---|---|
| | | w | A | RE | z | MnO$_2$ | | | | | |
| | | | | | | parts by mass | | | pC/N | GΩ·m | °C |
| * | 201 | 0.5 | Sr | - | - | - | No | No | 8 | 10 | 526 |
| * | 202 | 0.5 | Sr | - | - | 0.5 | Yes | Yes | 22 | 60 | 523 |
| | 203 | 0.5 | Sr | La | 0.050 | 0.5 | No | No | 22 | 65 | 521 |
| | 204 | 0.5 | Sr | La | 0.100 | 0.5 | No | No | 22 | 65 | 510 |
| | 205 | 0.5 | Sr | La | 0.200 | 0.5 | No | No | 21 | 65 | 508 |
| | 206 | 0.5 | Sr | La | 0.300 | 0.5 | No | No | 20 | 65 | 507 |
| * | 207 | 0.5 | Sr | La | 0.500 | 0.5 | No | No | 8 | 65 | 499 |
| * | 208 | 0.1 | Sr | La | 0.125 | 0.5 | No | No | 10 | 0.5 | 560 |
| * | 209 | 0.2 | Sr | La | 0.125 | 0.5 | No | No | 16 | 1 | 557 |
| * | 210 | 0.4 | Sr | La | 0.125 | 0.5 | No | No | 21 | 40 | 523 |
| * | 211 | 0.5 | Sr | La | 0.125 | 0.5 | No | No | 22 | 65 | 510 |
| * | 212 | 0.7 | Sr | La | 0.125 | 0.5 | No | No | 19 | 60 | 450 |
| * | 213 | 0.90 | Sr | La | 0.125 | 0.5 | No | No | 16 | 60 | 420 |
| * | 214 | 1.00 | Sr | La | 0.125 | 0.5 | No | No | 15 | 65 | 413 |
| * | 215 | 1.10 | Sr | La | 0.125 | 0.5 | No | No | 15 | 65 | 379 |
| * | 216 | 1.20 | Sr | La | 0.125 | 0.5 | No | No | 18 | 65 | 360 |
| | 217 | 1.40 | Sr | La | 0.125 | 0.5 | No | No | 21 | 60 | 322 |
| | 218 | 1.50 | Sr | La | 0.125 | 0.5 | No | No | 27 | 65 | 303 |
| | 219 | 1.70 | Sr | La | 0.125 | 0.5 | No | No | 24 | 65 | 247 |
| * | 220 | 1.90 | Sr | La | 0.125 | 0.5 | No | No | 23 | 65 | 230 |
| * | 221 | 2.00 | Sr | La | 0.125 | 0.5 | No | No | 24 | 60 | 220 |
| * | 222 | 2.20 | Sr | La | 0.125 | 0.5 | No | No | 24 | 60 | 222 |

| Sample No. | | Composition | | | | | Uneven dense distribution of Mn | Welding to firing jig | piezoelectric coefficient d33 | Specific volume resistivity | Curie temperature |
|---|---|---|---|---|---|---|---|---|---|---|---|
| | | w | A | RE | z | $MnO_2$ | | | | | |
| | | | | | | parts by mass | | | pC/N | GΩ·m | °C |
| * | 223 | 2.50 | Sr | La | 0.125 | 0.5 | No | No | 31 | 65 | 224 |
| * | 224 | 2.90 | Sr | La | 0.125 | 0.5 | No | No | 25 | 65 | 223 |
| * | 225 | 0.50 | Sr | Tb | 0.125 | 0.5 | No | No | 21 | 65 | 512 |
| * | 226 | 0.50 | Sr | Sm | 0.125 | 0.5 | No | No | 22 | 60 | 520 |
| * | 227 | 0.50 | Sr | Dy | 0.125 | 0.5 | No | No | 21 | 60 | 515 |
| * | 228 | 0.50 | Sr | Y | 0.125 | 0.5 | No | No | 20 | 60 | 513 |
| * | 229 | 0.50 | Sr | Gd | 0.125 | 0.5 | No | No | 21 | 65 | 512 |
| * | 230 | 0.50 | Sr | Nd | 0.125 | 0.5 | No | No | 22 | 65 | 510 |
| * | 231 | 0.50 | Sr | Er | 0.125 | 0.5 | No | No | 22 | 60 | 516 |
| * | 232 | 0.50 | Sr | Yb | 0.125 | 0.5 | No | No | 21 | 60 | 515 |
| * | 233 | 0.50 | Sr | Lu | 0.125 | 0.5 | No | No | 20 | 65 | 511 |
| * | 234 | 0.50 | Sr | Eu | 0.125 | 0.5 | No | No | 22 | 65 | 513 |
| * | 235 | 0.50 | Sr | La | 0.125 | 0.01 | No | No | 10 | 60 | 510 |
| * | 236 | 0.50 | Sr | La | 0.125 | 0.03 | No | No | 12 | 65 | 511 |
| * | 237 | 0.50 | Sr | La | 0.125 | 0.05 | No | No | 17 | 65 | 510 |
| * | 238 | 0.50 | Sr | La | 0.125 | 0.1 | No | No | 19 | 65 | 510 |
| * | 239 | 0.50 | Sr | La | 0.125 | 0.5 | No | No | 22 | 65 | 511 |
| * | 240 | 0.50 | Sr | La | 0.125 | 1.5 | No | No | 20 | 20 | 511 |
| * | 241 | 0.50 | Sr | La | 0.125 | 2.0 | No | No | 18 | 3 | 512 |
| * | 242 | 0.50 | Sr | La | 0.125 | 2.5 | No | No | 13 | 0.3 | 510 |
| * | 243 | 0.50 | Ba | La | 0.125 | 0.5 | No | No | 20 | 55 | 392 |
| * | 244 | 0.50 | Ca | La | 0.125 | 0.5 | No | No | 19 | 65 | 752 |

EP 2 119 686 B1

25

| Sample No. | | Composition | | | | MnO₂ | Uneven dense distribution of Mn | Welding to firing jig | piezoelectric coefficient d33 | Specific volume resistivity | Curie temperature |
|---|---|---|---|---|---|---|---|---|---|---|---|
| | | w | A | RE | z | parts by mass | | | pC/N | GΩ·m | °C |
| * | 245 | 0.50 | $(Na_{1/2}Bi_{1/2})$ | La | 0.125 | 0.5 | No | No | 22 | 55 | 502 |
| * | 246 | 0.50 | $(K_{1/2}Bi_{1/2})$ | La | 0.125 | 0.5 | No | No | 21 | 50 | 503 |
| * | 247 | 0.50 | $Sr_{1/2}Ca_{1/2}$ | La | 0.125 | 0.5 | No | No | 21 | 65 | 580 |
| * | 248 | 0.50 | $Sr_{1/2}Ba_{1/2}$ | La | 0.125 | 0.5 | No | No | 22 | 80 | 472 |
| * | 249 | 0.50 | $Ba_{1/2}Ca_{1/2}$ | La | 0.125 | 0.5 | No | No | 22 | 55 | 585 |
| * | 250 | 0.50 | $Sr_{1/2}(Na_{1/2}Bi_{1/2})_{1/2}$ | La | 0.125 | 0.5 | No | No | 22 | 60 | 509 |
| * | 251 | 0.50 | $Sr_{1/2}(K_{1/2}Bi_{1/2})_{1/2}$ | La | 0.125 | 0.5 | No | No | 22 | 55 | 507 |

The samples marked "*" are out of the scope of the present invention.

As is apparent from Table 7, in the samples from No. 203 to No. 206, 217 to 219 within the scope of the present invention, no uneven dense distribution of Mn was recognized in the grain boundary and therefore the samples were not welded to a kiln furniture.

In the sample No. 201 out of the scope of the present invention, since Mn was not added, the sample was not welded to a kiln furniture, but the piezoelectric ceramic was not adequately sintered, and the relative ceramic density was as low as about 80% compared with a piezoelectric ceramic having the relative ceramic density of 90% or more, in which 0.05 part by mass or more of Mn was added and the ceramic was chipped by slight handling. Therefore, the piezoelectric coefficient $d_{33}$ was low.

In the sample No. 202, since Mn was added, the piezoelectric ceramic was adequately sintered and the piezoelectric coefficient $d_{33}$ was increased, but uneven dense distribution of Mn was recognized in the grain boundary and therefore the samples were welded to a kiln furniture.

In the samples from No. 203 to No. 206, from No. 217 to No. 219, since each piezoelectric ceramics contains 100 parts by mass of a main component having the compositional formula represented by $Bi_4Ti_3O_{12} \cdot w(A_{1-z}RE_z) TiO_3$, wherein A represents $M1_\alpha (M2_{1/2}Bi_{1/2})_{1-\alpha}$, RE represents a rare earth element, and w, z and $\alpha$ satisfy the following formulae: $0.2 \leq w$, $0.05 \leq z \leq 0.3$ and $0 \leq \alpha \leq 1$, and 0.05 to 2.0 parts by mass of Mn in terms of the content of $MnO_2$, the piezoelectric coefficient $d_{33}$ was as high as 15 pC/N or more and the specific volume resistivity was as high as 3 GΩ·m or more.

In the samples from No. 203 to No. 206 and from No. 217 to No. 219, since w satisfies the formula, each piezoelectric coefficient $d_{33}$ was as high as 16 pC/N or more.

In the samples from No. 217 to No. 219, since w satisfies the formula, $1.4 \leq w \leq 1.7$, each piezoelectric coefficient $d_{33}$ was as high as 21 pC/N or more.

The results of evaluations of resonators for fundamental wave oscillation are shown in Table 8.

[Table 8]

| | Sampl No. | Composition | | | | | Uneven dense distribution of Mn | Welding to firing jig | P/V | Change rates of oscillating frequency upon temperature change | |
|---|---|---|---|---|---|---|---|---|---|---|---|
| | | w | A | RE | z | MnO$_2$ parts by mass | | | dB | 25°C →-20°C ppm | 25°C →80°C ppm |
| * | 201 | 0.5 | Sr | - | - | - | No | No | 58 | 5070 | -5100 |
| * | 202 | 0.5 | Sr | - | - | 0.5 | Yes | Yes | 64 | 5070 | -5100 |
| | 203 | 0.5 | Sr | La | 0.050 | 0.5 | No | No | 66 | 5030 | -5090 |
| | 204 | 0.5 | Sr | La | 0.100 | 0.5 | No | No | 73 | 5020 | -5085 |
| | 205 | 0.5 | Sr | La | 0.200 | 0.5 | No | No | 71 | 5030 | -5090 |
| | 206 | 0.5 | Sr | La | 0.300 | 0.5 | No | No | 63 | 5020 | -5080 |
| * | 207 | 0.5 | Sr | La | 0.500 | 0.5 | No | No | 55 | 5020 | -5085 |
| * | 208 | 0.1 | Sr | La | 0,125 | 0.5 | No | No | 32 | 5010 | -5060 |
| * | 209 | 0.2 | Sr | La | 0.125 | 0.5 | No | No | 33 | 5010 | -5055 |
| * | 210 | 0.4 | Sr | La | 0.125 | 0.5 | No | No | 70 | 5020 | -5080 |
| * | 211 | 0.5 | Sr | La | 0.125 | 0.5 | No | No | 74 | 5020 | -5060 |
| * | 212 | 0.7 | Sr | La | 0.125 | 0.5 | No | No | 80 | 5025 | -5065 |
| * | 213 | 0.90 | Sr | La | 0.125 | 0.5 | No | No | 71 | 5030 | -5070 |
| * | 214 | 1.00 | Sr | La | 0.125 | 0.5 | No | No | 72 | 5025. | -5070 |
| * | 215 | 1.10 | Sr | La | 0.125 | 0.5 | No | No | 67 | 5030 | -5075 |
| * | 216 | 1.20 | Sr | La | 0.125 | 0.5 | No | No | 65 | 5030 | -5075 |
| | 217 | 1.40 | Sr | La | 0.125 | 0.5 | No | No | 72 | 5025 | -5070 |
| | 218 | 1.50 | Sr | La | 0.125 | 0.5 | No | No | 73 | 5025 | -5065 |
| | 219 | 1.70 | Sr | La | 0.125 | 0.5 | No | No | 72 | 5025 | -5070 |
| * | 220 | 1.90 | Sr | La | 0.125 | 0.5 | No | No | 67 | 5030 | -5075 |
| * | 221 | 2.00 | Sr | La | 0.125 | 0.5 | No | No | 65 | 5035 | -5080 |
| * | 222 | 2.20 | Sr | La | 0.125 | 0.5 | No | No | 63 | 5030 | -5070 |

| Sampl No. | | Composition | | | | | Uneven dense distribution of Mn | Welding to firing jig | P/V | Change rates of oscillating frequency upon temperature change | |
|---|---|---|---|---|---|---|---|---|---|---|---|
| | | w | A | RE | z | $MnO_2$ | | | | 25°C →-20°C | 25°C →80°C |
| | | | | | | parts by mass | | | dB | ppm | ppm |
| * | 223 | 2.50 | Sr | La | 0.125 | 0.5 | No | No | 61 | 5030 | -5060 |
| * | 224 | 2.90 | Sr | La | 0.125 | 0.5 | No | No | 58 | 5030 | -5065 |
| * | 225 | 0.50 | Sr | Tb | 0.125 | 0.5 | No | No | 73 | 5030 | -5065 |
| * | 226 | 0.50 | Sr | Sm | 0.125 | 0.5 | No | No | 72 | 5030 | -5060 |
| * | 227 | 0.50 | Sr | Dy | 0.125 | 0.5 | No | No | 73 | 5035 | -5065 |
| * | 228 | 0.50 | Sr | Y | 0.125 | 0.5 | No | No | 74 | 5030 | -5060 |
| * | 229 | 0.50 | Sr | Gd | 0.125 | 0.5 | No | No | 72 | 5035 | -5060 |
| * | 230 | 0.50 | Sr | Nd | 0.125 | 0.5 | No | No | 74 | 5030 | -5065 |
| * | 231 | 0.50 | Sr | Er | 0.125 | 0.5 | No | No | 73 | 5030 | -5060 |
| * | 232 | 0.50 | Sr | Yb | 0.125 | 0.5 | No | No | 74 | 5035 | -5060 |
| * | 233 | 0.50 | Sr | Lu | 0.125 | 0.5 | No | No | 73 | 5030 | -5060 |
| * | 234 | 0.50 | Sr | Eu | 0.125 | 0.5 | No | No | 72 | 5030 | -5060 |
| * | 243 | 0.50 | Ba | La | 0.125 | 0.5 | No | No | 70 | 2370 | -2500 |
| * | 244 | 0.50 | Ca | La | 0.125 | 0.5 | No | No | 71 | 2380 | -2520 |
| * | 245 | 0.50 | $(Na_{1/2}Bi_{1/2})$ | La | 0.125 | 0.5 | No | No | 74 | 3920 | -4150 |
| * | 246 | 0.50 | $(K_{1/2}Bi_{1/2})$ | La | 0.125 | 0.5 | No | No | 73 | 3940 | -4210 |
| * | 247 | 0.50 | $Sr_{1/2}Ca_{1/2}$ | La | 0.125 | 0.5 | No | No | 75 | 2980 | -2990 |
| * | 248 | 0.50 | $Sr_{1/2}Ba_{1/2}$ | La | 0.125 | 0.5 | No | No | 73 | 2850 | -2900 |
| * | 249 | 0.50 | $Ba_{1/2}Ca_{1/2}$ | La | 0.125 | 0.5 | No | No | 70 | 2970 | -3000 |
| * | 250 | 0.50 | $Sr_{1/2}(Na_{1/2}Bi_{1/2})_{1/2}$ | La | 0.125 | 0.5 | No | No | 72 | 3990 | -4100 |
| * | 261 | 0.50 | $Sr_{1/2}(K_{1/2}B_{1/2})_{1/2}$ | La | 0.125 | 0.5 | No | No | 71 | 3980 | -4080 |
| | 252 | 1.50 | $Sr_{0.8}Ca_{0.2}$ | La | 0.200 | 0.5 | No | No | 70 | 1990 | -1980 |

EP 2 119 686 B1

The samples marked "*" are out of the scope of the present invention.

It is found from Table 8 that in the sample No. 252 in which the rare earth element was added and $Sr_{0.8}Ca_{0.2}$ was used as A, P/V can be increased to 70, and the change rates of the oscillating frequency upon temperature change can be made as small as within $\pm 2000$ ppm.

Further, samples in another group were evaluated and the results are shown in Table 9. The piezoelectric ceramic for the evaluation of lapping was processed to a thickness of 0.1 mm with No. 2000 by lapping. 100 pieces of the piezoelectric ceramics were lapped and piezoelectric ceramics without cracks and chipping were rated as good and the yields were determined.

The minimum firing temperature shown in Table 9 means the lowest firing temperature at which a suitable ceramic is obtained, and means the lowest temperature among firing temperatures at which piezoelectric ceramics, which have a relative density equivalent to that of the piezoelectric ceramic fired at a firing temperature at which the relative ceramic density becomes the highest in a range of firing temperatures of 1050 to 1250°C, are obtained.

[Table 9]

| | Sample No. | Composition | | | | Minimum firing temperature | Relative ceramic density | Yield of lapping | piezoelectric coefficient d33 | Specific volume resistivity |
|---|---|---|---|---|---|---|---|---|---|---|
| | | w | A | y | $MnO_2$ parts by mass | °C | % | % | pC/N | GΩ·m |
| * | 301 | 0 | - | - | 0.5 | 1180 | 99 | 68 | 16 | 0.5 |
| * | 302 | 0.5 | $Na_{1/2}Bi_{1/2}$ | - | 0.5 | 1140 | 99 | 78 | 19 | 65 |
| * | 303 | 0.75 | $Na_{1/2}Bi_{1/2}$ | - | 0.5 | 1140 | 99 | 87 | 17 | 65 |
| * | 304 | 1 | $Na_{1/2}Bi_{1/2}$ | - | 0.5 | 1150 | 99 | 67 | 16 | 65 |
| * | 305 | 1.1 | $Na_{1/2}Bi_{1/2}$ | - | 0.5 | 1140 | 99 | 71 | 17 | 65 |
| | 306 | 1.2 | $Na_{1/2}Bi_{1/2}$ | - | 0.5 | 1100 | 99 | 91 | 20 | 65 |
| | 307 | 1.3 | $Na_{1/2}Bi_{1/2}$ | - | 0.5 | 1100 | 99 | 92 | 22 | 65 |
| | 308 | 1.4 | $Na_{1/2}Bi_{1/2}$ | - | 0.5 | 1100 | 99 | 90 | 24 | 65 |
| | 309 | 1.5 | $Na_{1/2}Bi_{1/2}$ | - | 0.5 | 1100 | 99 | 92 | 26 | 65 |
| | 310 | 1.6 | $Na_{1/2}Bi_{1/2}$ | - | 0.5 | 1100 | 99 | 91 | 25 | 65 |
| | 311 | 1.7 | $Na_{1/2}Bi_{1/2}$ | - | 0.5 | 1120 | 99 | 93 | 24 | 65 |
| | 312 | 1.8 | $Na_{1/2}Bi_{1/2}$ | - | 0.5 | 1150 | 99 | 91 | 22 | 65 |
| | 313 | 1.9 | $Na_{1/2}Bi_{1/2}$ | - | 0.5 | 1160 | 99 | 90 | 21 | 60 |
| * | 314 | 2 | $Na_{1/2}Bi_{1/2}$ | - | 0.5 | 1220 | 99 | 66 | 20 | 60 |
| * | 315 | 2.1 | $Na_{1/2}Bi_{1/2}$ | - | 0.5 | 1200 | 99 | 67 | 21 | 60 |
| * | 316 | 0.75 | $Li_{1/2}Bi_{1/2}$ | - | 0.5 | 1090 | 99 | 76 | 16 | 65 |
| | 317 | 1.5 | $Li_{1/2}Bi_{1/2}$ | - | 0.5 | 1090 | 99 | 92 | 24 | 65 |
| * | 318 | 0.75 | $K_{1/2}Bi_{1/2}$ | - | 0.5 | 1100 | 99 | 72 | 17 | 65 |
| | 319 | 1.5 | $K_{1/2}Bi_{1/2}$ | - | 0.5 | 1100 | 99 | 91 | 23 | 65 |
| | 320 | 0.75 | Sr | - | 0.5 | 1150 | 99 | 66 | 16 | 65 |
| | 321 | 1.5 | Sr | - | 0.5 | 1250 | 96 | 76 | 25 | 60 |
| | 322 | 1.5 | $Na_{1/2}Bi_{1/2}$ | 0.05 | 0.5 | 1100 | 99 | 90 | 27 | 65 |
| | 323 | 1.5 | $Na_{1/2}Bi_{1/2}$ | 0.10 | 0.5 | 1090 | 99 | 92 | 31 | 65 |

EP 2 119 686 B1

| | Sample No. | Composition | | | | Minimum firing temperature | Relative ceramic density | Yield of lapping | piezoelectric coefficient d33 | Specific volume resistivity |
|---|---|---|---|---|---|---|---|---|---|---|
| | | w | A | y | $MnO_2$ | | | | | |
| | | | | | parts by mass | °C | % | % | pC/N | GΩ·m |
| | 324 | 1.5 | $Na_{1/2}Bi_{1/2}$ | 0.15 | 0.5 | 1090 | 99 | 92 | 29 | 65 |
| | 325 | 1.5 | $Na_{1/2}Bi_{1/2}$ | 0.20 | 0.5 | 1080 | 99 | 92 | 27 | 65 |
| | 326 | 1.5 | $Na_{1/2}Bi_{1/2}$ | 0.25 | 0.5 | 1070 | 99 | 93 | 24 | 65 |
| | 327 | 1.5 | $Na_{1/2}Bi_{1/2}$ | 0.30 | 0.5 | 1070 | 99 | 92 | 23 | 65 |
| * | 328 | 1.5 | $Na_{1/2}Bi_{1/2}$ | 0.35 | 0.5 | 1070 | 99 | 92 | 19 | 65 |
| * | 329 | 1.5 | $Na_{1/2}Bi_{1/2}$ | 0.40 | 0.5 | 1070 | 99 | 91 | 17 | 65 |
| | 330 | 1.5 | $Na_{1/2}Bi_{1/2}$ | 0.10 | 0.5 | 1070 | 99 | 90 | 26 | 65 |
| | 331 | 1.5 | $K_{1/2}Bi_{1/2}$ | 0.10 | 0.5 | 1080 | 99 | 91 | 27 | 65 |
| * | 332 | 1.5 | $Na_{1/2}Bi_{1/2}$ | - | - | 1200 | 89 | 37 | 20 | 10 |
| | 333 | 1.5 | $Na_{1/2}Bi_{1/2}$ | - | 0.05 | 1180 | 95 | 90 | 22 | 60 |
| | 334 | 1.5 | $Na_{1/2}Bi_{1/2}$ | - | 0.2 | 1160 | 98 | 91 | 23 | 65 |
| | 335 | 1.5 | $Na_{1/2}Bi_{1/2}$ | - | 1.0 | 1100 | 99 | 92 | 23 | 65 |
| | 336 | 1.5 | $Na_{1/2}Bi_{1/2}$ | - | 1.5 | 1090 | 99 | 92 | 22 | 20 |
| | 337 | 1.5 | $Na_{1/2}Bi_{1/2}$ | - | 2.0 | 1080 | 99 | 91 | 21 | 3 |
| * | 1338 | 1.5 | $Na_{1/2}Bi_{1/2}$ | - | 2.5 | 1080 | 99 | 92 | - | 0.3 |

The samples marked "*" are out of the scope of the present invention.

As is apparent from Table 3, in the samples from No. 306 to No. 313, No. 317, from No. 319 to No. 327, No. 330, No. 331 and from No. 333 to No. 337 within the scope of the present invention, when the compound is represented by the compositional formula: $Bi_4Ti_3O_{12} \cdot w\{(1-x)(A_{1-y-z}Bi_yRE_zTiO_3) \cdot xBiFeO_3\}$, wherein A represents $M1_\alpha(M2_{1/2}Bi_{1/2})_{1-\alpha}$, M1 represents an alkaline earth metal element, M2 represents an alkali metal element, RE represents a rare earth element and x, y, z and $\alpha$ satisfy the following formulae: $0 \leq x \leq 0.10$, $0 \leq y + z \leq 0.30$ and $0 \leq \alpha \leq 1$, since w satisfies the formula, $1.30 \leq w \leq 1.75$, the piezoelectric coefficient $d_{33}$ can be made larger than a bismuth layered compound, in which A is the same and m = 4 (w = 1) or a bismuth layered compound, in which A is the same and m = 5 (w = 2).

As is apparent from Table 9, in the samples from No. 306 to No. 313, No. 317, No. 319, from No. 322 to No. 327, No. 330, No. 331 and from No. 333 to No. 337 within the scope of the present invention, since $\alpha = 0$, and the amount of Mn is 2.0 parts by mass or less in terms of the content of an oxide ($MnO_2$), the samples can be fired at 1180°C and the yield of lapping was as high as 90% or more. Further, the piezoelectric coefficient $d_{33}$ was also as high as 20 pC/N or more.

Further, the samples No. 320 and No. 321 represented by the compositional formula, $Bi_4Ti_3O_{12} \cdot w(SrTiO_3)$ were only sintered to such an extent that the relative density was 96% even under a firing temperature of 1250°C since the samples were not replaced with ($M2_{1/2}Bi_{1/2}$) of a bivalent ion, and the yield of lapping was low.

Particularly, in the samples from No. 322 to No. 326 within the scope of the present invention, since y satisfies the formula, $0.05 \leq y \leq 0.2$, the piezoelectric coefficient $d_{33}$ was as high as 26 pC/N or more.

On the other hand, in the samples from No. 301 to No. 305, from No. 314 to No. 316, No. 318 and No. 320, in which the value of w was out of the scope of the present invention, the relative ceramic densities were as high as 99%, but the yield of lapping was as low as less than 90%.

Further, in the samples No. 328 and No. 329 out of the scope of the present invention, in which y satisfies the formula, y > 0.3, the piezoelectric coefficient $d_{33}$ was also smaller than 20 pC/N.

Further, in the sample No. 332 out of the scope of the present invention, in which $MnO_2$ was not added, the relative ceramic density was less than 89% and the ceramic did not become adequately compact. The sample No. 338, in which the amount of $MnO_2$ added was 2.5 parts by mass, was subjected to a polarization treatment, but it could not be polarized.

The samples No. 4, No. 104, No. 136, and No. 314 were analyzed by X-ray diffraction, and consequently the bismuth layered compound in the case of m = 5 was recognized as a main crystal phase. Further, in the sample No. 304, the bismuth layered compound in the case of m = 4 was recognized as a main crystal phase. The bismuth layered compound has a crystal structure in which $Bi_2O_2$ is inserted into the laminated perovskite structures. The number of units of the perovskite structure sandwiched between the $Bi_2O_2$ layers represents m. From this fact, it is conceivable that the perovskite compound is introduced into the bismuth layered compound in the case of m = 3 to come to have a crystal in the case of m = 5. It is thought that in the piezoelectric ceramic of the present invention, the structures in the case where m is 4 and in the case where m is 5 coexist. Therefore, it is thought that the bismuth layered compound comes into a state in which a part of A constituting the pseudo-perovskite layer of the bismuth layered compound represented by $Bi_4Ti_3O_{i2} \cdot wATiO_3$ is replaced with Bi and RE and a part of Ti is replaced with Fe. Furthermore, in the ceramics containing Mn, the pseudo-perovskite layer is thought to be a bismuth layered compound in which Mn is partially intercrystallized in a structure of the bismuth layered compound. Further, cross sections of the samples were observed, and consequently the bismuth layered compound made up 90% or more of observed area.

All of the samples in Table 3 were analyzed by X-ray diffraction, and consequently the bismuth layered compound was recognized as a main component.

The composition of the samples prepared in examples was analyzed with a fluorescent X-ray analyzer, and consequently the composition of the ceramic of the samples was identical to those of the raw materials prepared.

**Claims**

1. A piezoelectric ceramic predominantly composed of a bismuth layered compound, comprising

    100 parts by mass of a component represented by the compositional formula:

    $Bi_4Ti_3O_{12} \cdot w\{(1-x)A_{1-y-z}Bi_yRE_zTiO_3 \cdot xBiFeO_3\}$, wherein A represents $M1_\alpha(M2_{1/2}Bi_{1/2})_{1-\alpha}$, M1 represents an alkaline earth metal element, M2 represents an alkali metal element, RE represents a rare earth element, and w, x, y, z and $\alpha$ satisfy the following formulae: $1.30 \leq w \leq 1.75$, $0 \leq x \leq 0.10$, $0 \leq y + z \leq 0.30$ and $0 \leq \alpha \leq 1$, and

    0.05 part by mass or more of Mn in terms of the content of an oxide ($MnO_2$).

**2.** The piezoelectric ceramic according to claim 1, wherein $\alpha$ = 0, and the amount of Mn is 2.0 parts by mass or less in terms of the content of an oxide ($MnO_2$).

**3.** The piezoelectric ceramic according to claim 1, wherein y = 0, z = 0 and $\alpha$ = 1, M1 represents $(Sr_{1-a}Ca_a)_{1-b}Ba_b$, wherein a and b satisfy the following formulae: $0.40 \leq a \leq 0.60$ and $0 \leq b \leq 0.20$, and the amount of the Mn is 1.5 parts by mass or less in terms of the content of an oxide ($MnO_2$).

**4.** The piezoelectric ceramic according to claim 3, wherein x satisfies the formula, $0.005 \leq x$.

**5.** A piezoelectric ceramic predominantly composed of a bismuth layered compound, wherein the compound is represented by the compositional formula:

$Bi_4Ti_3O_{12} \cdot w\{(1-x) ATiO_3 \cdot xBiFeO_3\}$, A represents $M1_\alpha(M2_{1/2}Bi_{1/2})_{1-\alpha}$, M1 represents an alkaline earth metal element, M2 represents an alkali metal element and w and x satisfy the following formulae: $1.30 \leq w \leq 1.75$ and $0.02 \leq x \leq 0.10$.

**6.** The piezoelectric ceramic according to claim 5, wherein $\alpha$ = 1, M1 represents $Sr_{1-a}Ca_a$, and a satisfies the formula, $0.40 \leq a \leq 0.60$.

**7.** The piezoelectric ceramic according to any one of claims 1 to 6, wherein the amount of spontaneous polarization is 12 $\mu C/cm^2$ or more, and the change rate of spontaneous polarization upon temperature change in a range of -40 to +200°C relative to the amount of spontaneous polarization at 25°C is 5% or less.

**8.** The piezoelectric ceramic according to claim 1, wherein y satisfies the formula, $0.05 \leq y \leq 0.20$, and the amount of Mn is 2.0 parts by mass or less in terms of the content of an oxide ($MnO_2$).

**9.** The piezoelectric ceramic according to claim 1, wherein z satisfies the formula, $0.05 \leq z$, and the amount of Mn is 2.0 parts by mass or less in terms of the content of an oxide ($MnO_2$).

**10.** The piezoelectric ceramic according to claim 9, wherein w satisfies the formula: $1.4 \leq w \leq 1.7$.

**11.** A piezoelectric ceramic predominantly composed of a bismuth layered compound and containing Mn, wherein Mn is not unevenly distributed between grains predominantly composed of the bismuth layered compound, and comprising 100 parts by mass of a main component represented by the compositional formula:

$Bi_4Ti_3O_{12} \cdot w(A_{1-z}RE_z)TiO_3$, wherein A represents $M1_\alpha(M2_{1/2}Bi_{1/2})_{1-\alpha}$, M1 represents an alkaline earth metal element, M2 represents an alkali metal element, RE represents a rare earth element, and w, z and $\alpha$ satisfy the following formulae: $1.4 \leq w \leq 1.7$, $0.05 \leq z \leq 0.3$ and $0 \leq \alpha \leq 1$, and 0.05 to 2.0 parts by mass of Mn in terms of the content of an oxide ($MnO_2$).

**12.** A piezoelectric element comprising the piezoelectric ceramic according to any one of claims 1 to 11, and a pair of electrodes opposed to each other with the piezoelectric ceramic sandwiched therebetween.

**13.** The piezoelectric element according to claim 12, being operated by thickness extensional vibration.

**Patentansprüche**

**1.** Piezoelektrische Keramik, hauptsächlich zusammengesetzt aus einer Wismut-geschichteten Verbindung, umfassend
100 Massenteile einer Komponente, dargestellt durch die Zusammensetzungsformel:

$Bi_4Ti_3O_{12} \cdot w\{(1-x)A_{1-y-z}Bi_yRE_zTiO_3 \cdot xBiFeO_3\}$, worin A $M1_\alpha(M2_{1/2}Bi_{1/2})_{1-\alpha}$ ist, M1 ein Erdalkalimetallelement ist, M2 ein Alkalimetallelement ist, RE ein Seltenerdelement ist und w, x, y, z und $\alpha$ die folgenden Formeln erfüllen: $1{,}30 \leq w \leq 1{,}75$, $0 \leq x \leq 0{,}10$, $0 \leq y + z \leq 0{,}3$ 0 und $0 \leq \alpha \leq 1$ und

0,05 Massenteile oder mehr Mn, ausgedrückt als Gehalt eines Oxides ($MnO_2$).

**2.** Piezoelektrische Keramik nach Anspruch 1, worin $\alpha$ 0 ist und die Menge von Mn 2,0 Massenteile oder weniger ist, ausgedrückt als Gehalt eines Oxides ($MnO_2$).

**3.** Piezoelektrische Keramik nach Anspruch 1, worin y = 0, z = 0 und $\alpha$ = 1, M1 $(Sr_{1-a}Ca_a)_{1-b}Ba_b$ ist, worin a und b die folgenden Formeln erfüllen: $0{,}40 \leq a \leq 0{,}60$ und $0 \leq b \leq 0{,}20$, und die Menge von Mn 1,5 Massenteile oder weniger ist, ausgedrückt als Gehalt eines Oxides ($MnO_2$).

**4.** Piezoelektrische Keramik nach Anspruch 3, worin x die Formel $0{,}005 \leq x$ erfüllt.

**5.** Piezoelektrische Keramik, hauptsächlich zusammengesetzt aus einer Wismut-geschichteten Verbindung, worin die Verbindung durch die Zusammensetzungsformel dargestellt ist:

$Bi_4Ti_3O_{12} \cdot w\{(1\text{-}x)ATiO_3 \cdot xBiFeO_3\}$, worin A $M1_\alpha(M2_{1/2}Bi_{1/2})_{1-\alpha}$ ist, M1 ein Erdalkalimetallelement ist, M2 ein Alkalimetallelement ist und w und x die folgenden Formeln erfüllen: $1{,}30 \leq w \leq 1{,}75$ und $0{,}02 \leq x \leq 0{,}10$.

**6.** Piezoelektrische Keramik nach Anspruch 5, worin $\alpha$ 1 ist, M1 $Sr_{1-a}Ca_a$ ist und a die Formel $0{,}40 \leq a \leq 0{,}60$ erfüllt.

**7.** Piezoelektrische Keramik nach einem der Ansprüche 1 bis 6, worin die Menge der spontanen Polarisierung 12 $\mu C/cm^2$ oder mehr ist und die Änderungsrate der spontanen Polarisierung bei Temperaturänderung in einem Bereich von -40 bis +200°C in Bezug auf die Menge der spontanen Polarisierung bei 25°C 5% oder weniger ist.

**8.** Piezoelektrische Keramik nach Anspruch 1, worin y die Formel $0{,}05 \leq y \leq 0{,}20$ erfüllt und die Menge an Mn 2,0 Massenteile oder weniger ist, ausgedrückt als Gehalt eines Oxides ($MnO_2$).

**9.** Piezoelektrische Keramik nach Anspruch 1, worin z die Formel $0{,}05 \leq z$ erfüllt und die Menge an Mn 2,0 Massenteile oder weniger ist, ausgedrückt als Gehalt eines Oxides ($MnO_2$).

**10.** Piezoelektrische Keramik nach Anspruch 9, worin w die Formel $1{,}4 \leq w \leq 1{,}7$ erfüllt.

**11.** Piezoelektrische Keramik, die sich hauptsächlich aus einer Wismut-geschichteten Verbindung zusammensetzt und Mn enthält, worin Mn nicht uneben zwischen Körnern verteilt ist, die sich hauptsächlich aus der Wismut-geschichteten Verbindung zusammensetzen, und
umfassend 100 Massenteile einer Hauptkomponente, dargestellt durch die Zusammensetzungsformel:

$Bi_4Ti_3O_{12} \cdot w(A_{1-z}RE_z)TiO_3$, worin A $M1_\alpha(M2_{1/2}Bi_{1/2})_{1-\alpha}$ ist, M1 ein Erdalkalimetallelement ist, M2 ein Alkalimetallelement ist, RE ein Seltenerdelement ist und w, z und $\alpha$ die folgenden Formeln erfüllen: $1{,}4 \leq w \leq 1{,}7$, $0{,}05 \leq z \leq 0{,}3$ und $0 \leq \alpha \leq 1$ und 0,05 bis 2,0 Massenteile Mn, ausgedrückt als Gehalt eines Oxides ($MnO_2$).

**12.** Piezoelektrisches Element, umfassend die piezoelektrische Keramik nach einem der Ansprüche 1 bis 11 und ein Paar von Elektroden, die einander gegenüberliegend angeordnet sind, wobei die piezoelektrische Keramik zwischen diesen in Sandwichform angeordnet ist.

**13.** Piezoelektrisches Element nach Anspruch 12, das durch Dickenextensionsvibration betrieben wird.

**Revendications**

**1.** Une céramique piézoélectrique composée majoritairement d'un composé de bismuth en couches, comprenant 100 parties en masse d'un composant représenté par la formule de composition:

$Bi_4Ti_3O_{12} \cdot w\{(1\text{-}x)A_{1-y-z}Bi_yRE_zTiO_3 \cdot xBiFeO_3\}$, dans laquelle A représente $M1_\alpha(M2_{1/2}Bi_{1/2})_{1-\alpha}$, M1 représente un élément métallique alcalino-terreux, M2 représente un élément métallique alcalin, RE représente un élément de terre rare, et w, x, y, z et $\alpha$ satisfont les formules suivantes: $1{,}30 \leq w \leq 1{,}75$, $0 \leq x \leq 0{,}10$, $0 \leq y + z \leq 0{,}30$ et $0 \leq \alpha \leq 1$, et

0,05 parties en masse ou plus de Mn en termes de la teneur d'un oxyde ($MnO_2$).

**2.** La céramique piézoélectrique selon la revendication 1, dans laquelle $\alpha$ = 0, et la quantité de Mn est de 2,0 parties en masse ou moins en termes de la teneur d'un oxyde ($MnO_2$).

**3.** La céramique piézoélectrique selon la revendication 1, dans laquelle y = 0, z = 0 et $\alpha$ = 1, M1 représente $(Sr_{1-a}Ca_a)_{1-b}Ba_b$, où a et b satisfont les formules suivantes: $0,40 \leq a \leq 0,60$ et $0 \leq b \leq 0,20$, et la quantité du Mn est de 1,5 parties en masse ou moins en termes de la teneur d'un oxyde ($MnO_2$).

**4.** La céramique piézoélectrique selon la revendication 3, dans laquelle x satisfait la formule, $0,005 \leq x$.

**5.** Une céramique piézoélectrique composée majoritairement d'un composé de bismuth en couches, dans laquelle le composé est représenté par la formule de composition:

$Bi_4Ti_3O_{12}\cdot w\{(1-x)ATiO_3 \cdot xBiFeO_3\}$, A représente $M1_\alpha (M2_{1/2}Bi_{1/2})_{1-\alpha}$, M1 représente un élément métallique alcalino-terreux, M2 représente un élément métallique alcalin et w et x satisfont les formules suivantes: $1,30 \leq w \leq 1,75$ et $0,02 \leq x \leq 0,10$.

**6.** La céramique piézoélectrique selon la revendication 5, dans laquelle $\alpha$ = 1, M1 représente $Sr_{1-a}Ca_a$, et a satisfait la formule, $0,40 \leq a \leq 0,60$.

**7.** La céramique piézoélectrique selon l'une quelconque des revendications 1 à 6, dans laquelle la quantité de polarisation spontanée est de 12 $\mu C/cm^2$ ou plus, et la vitesse de changement de polarisation spontanée pour un changement de température dans une fourchette de -40 à +200°C par rapport à la quantité de polarisation spontanée à 25°C est de 5% ou moins.

**8.** La céramique piézoélectrique selon la revendication 1, dans laquelle y satisfait la formule, $0,05 \leq y \leq 0,20$, et la quantité de Mn est de 2,0 parties en masse ou moins en termes de la teneur d'un oxyde ($MnO_2$).

**9.** La céramique piézoélectrique selon la revendication 1, dans laquelle z satisfait la formule, $0,05 \leq z$, et la quantité de Mn est de 2,0 parties en masse ou moins en termes de la teneur d'un oxyde $MnO_2$).

**10.** La céramique piézoélectrique selon la revendication 9, dans laquelle w satisfait la formule: $1,4 \leq w \leq 1,7$.

**11.** Une céramique piézoélectrique composée majoritairement d'un composé de bismuth en couches et contenant du Mn, dans laquelle le Mn n'est pas réparti uniformément entre des grains composés majoritairement du composé de bismuth en couches, et

comprenant 100 parties en masse d'un composant principal représenté par la formule de composition:

$Bi_4Ti_3O_{12}\cdot w(A_{1-z}RE_z)TiO_3$, dans laquelle A représente $M1_\alpha (M2_{1/2}Bi_{1/2})_{1-\alpha}$, M1 représente un élément métallique alcalino-terreux, M2 représente un élément métallique alcalin, RE représente un élément de terre rare, et w, z et $\alpha$ satisfont les formules suivantes: $1,4 \leq w \leq 1,7$, $0,05 \leq z \leq 0,3$ et $0 \leq \alpha \leq 1$, et de 0,05 à 2,0 parties en masse de Mn en termes de la teneur d'un oxyde ($Mn0_2$).

**12.** Un élément piézoélectrique comprenant la céramique piézoélectrique selon l'une quelconque des revendications 1 à 11, et une paire d'électrodes face à face l'une de l'autre avec la céramique piézoélectrique prise en sandwich entre elles.

**13.** L'élément piézoélectrique selon la revendication 12, qui fonctionne par vibration d'extension d'épaisseur.

Fig. 1

Amplifying circuit

| Gain | $\alpha$ |
| Amount of phase shift | $\theta_1$ |

Amplifying circuit

| Feedback factor | $\beta$ |
| Amount of phase shift | $\theta_2$ |

Fig. 2

Fig. 3

(a)

(b)

**EP 2 119 686 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002167276 A